# EUROPEAN PATENT APPLICATION

(11) **EP 4 834 577 A1**
(43) Date of publication of application: **04.11.2026**
(21) Application number: 24912917.2
(22) Date of filing: 25.12.2024
(51) Int. Cl.: B32B 5/10, B25J 15/08, B32B 27/38, C08J 5/04

(54) **LAMINATE AND METHOD FOR MANUFACTURING SAME, TRANSFER HAND, TRANSFER DEVICE, AND SEMICONDUCTOR MANUFACTURING DEVICE**

(30) Priority: 26.12.2023 JP 2023219753
(71) Applicant: Mitsubishi Chemical Corporation, Tokyo 100-8251 (JP)
(72) Inventor: IGARASHI, Hiroshi, Tokyo 100-8251 (JP); WATANABE, Azusa, Tokyo 100-8251 (JP)
(74) Representative: Hoffmann Eitle
(86) International application number: PCT/JP2024/045928
(87) International publication number: WO 2025/143031

(57) **Abstract**

Provided are a laminate excellent in vibration damping properties and a method for manufacturing the same, a laminate and a method for manufacturing the same, a transfer hand, a transfer device, and a semiconductor manufacturing device. A laminate including a plurality of first layers (a) and a second layer (b), in which each of the plurality of first layers (a) is a layer selected from a carbon fiber-reinforced resin layer (a1), a ceramic layer (a2), and a metallic layer (a3); the second layer (b) is a layer selected from a layer (b1) mainly containing an epoxy resin (S) (provided that the carbon fiber-reinforced resin layer (a1) is excluded), and a layer (b2) mainly containing a thermoplastic elastomer (T); the first layers (a) are disposed on both surfaces of the second layer (b); and a proportion of a thickness of the second layer (b) to a total thickness of the first layers (a) and the second layer (b) is 0.3% or more and less than 30%.

## Description

### Technical Field

The present invention relates to a laminate and a method for manufacturing the same, a transfer hand, a transfer device, and a semiconductor manufacturing device.

The present application claims the rights of priority on the basis of Japanese Patent Application No. 2023-219753 filed in Japan on December 26, 2023, the content of which is incorporated herein by reference.

### Background Art

As a transfer device that transfers a semiconductor wafer or the like, a transfer robot, for example, is used. The transfer robot has a transfer hand, a fork, a pick, and an end effector (hereinafter referred to as transfer hand) that handle a semiconductor wafer as a workpiece.

Ceramic, which is an isotropic material, has a high Young's modulus and a small total amount of deflection under its own weight and deflection under load when a semiconductor wafer is placed thereon, and therefore is generally used as a material for the transfer hand. Aluminum is also used in applications where a high Young's modulus is not required.

The transfer hand vibrates in the vertical direction when the semiconductor wafer is placed thereon, or when the load is removed after the semiconductor wafer is delivered. In addition, vibration is also generated when the transfer device is suddenly stopped. Further, there is also a problem that, if the wafer is placed without stopping the vibration, the position of the wafer is shifted. As described above, the operation of the transfer device has various problems, and it is desired that the vibration should settle down in a short time, that is, vibration damping properties should be improved, from the viewpoint of shortening a tact time in a transfer process of the semiconductor wafer.

A ceramic transfer hand is likely to vibrate when the semiconductor wafer is placed thereon or delivered. In addition, ceramic has low impact resistance, and may be damaged by contact with a semiconductor wafer or a delivery destination during use.

Therefore, as a transfer hand having excellent vibration damping properties, a transfer hand made of carbon fiber-reinforced plastic has been proposed (for example, see Patent Document 1).

### Citation List

### Patent Document

Patent Document 1: WO 2005/102618

### Summary of Invention

### Technical Problem

However, known transfer hands made of carbon fiber-reinforced plastic, ceramic, or the like do not necessarily have sufficient vibration damping properties.

An object of the present invention is to provide a laminate excellent in vibration damping properties and a method for manufacturing the same, a transfer hand, a transfer device, and a semiconductor manufacturing device.

### Solution to Problem

The present invention includes the following aspects.
[1] A laminate including a plurality of first layers (a) and a second layer (b), in which
   each of the plurality of first layers (a) is a layer selected from a carbon fiber-reinforced resin layer (a1), a ceramic layer (a2), and a metallic layer (a3),
   the second layer (b) is a layer selected from a layer (b1) mainly containing an epoxy resin (S) (provided that the carbon fiber-reinforced resin layer (a1) is excluded), and a layer (b2) mainly containing a thermoplastic elastomer (T),
   the first layers (a) are disposed on both surfaces of the second layer (b), and
   a proportion of a thickness of the second layer (b) to a total thickness of the first layers (a) and the second layer (b) is 0.3% or more and less than 30%.
[2] The laminate according to [1], in which the laminate has a total thickness of from 1.5 to 20 mm.
[3] The laminate according to [1] or [2], in which the carbon fiber-reinforced resin layer (a1) includes both a layer containing pitch-based carbon fibers and a layer containing PAN-based carbon fibers.
[4] The laminate according to any one of [1] to [3], in which the layer (b1) containing the epoxy resin (S) has an elongation at break of 100% or more and 500% or less.
[5] The laminate according to any one of [1] to [4], in which the layer (b2) containing the thermoplastic elastomer (T) has an elongation at break of 800% or more and 1200% or less.
[6] The laminate according to any one of [1] to [5], in which the metallic layer (a3) is any one of an aluminum layer, a SUS layer, and a titanium alloy layer.
[7] The laminate according to any one of [1] to [6], in which the epoxy resin (S) has an aliphatic hydrocarbon skeleton.
[8] The laminate according to any one of [1] to [7], in which the second layer (b) has a thickness of 0.03 mm or more and 0.5 mm or less.
[9] The laminate precursor according to any one of [3] to [8], in which the pitch-based carbon fibers have a tensile modulus of 600 GPa or more and 800 GPa or less.
[10] The laminate according to any one of [3] to [9], in which the PAN-based carbon fibers have a tensile modulus of 200 GPa or more and 400 GPa or less.
[11] The laminate according to any one of [1] to [10], in which
   the carbon fiber-reinforced resin layer (a1) includes a layer (a11₀) containing pitch-based carbon fibers aligned in one direction and a cured product of an epoxy resin (N1), and a layer (β) containing carbon fibers oriented at an orientation angle of 45° or more and 90° or less relative to orientation of the pitch-based carbon fibers contained in the layer (a11₀), and
   the layer (β) includes at least one of a layer (a11) containing pitch-based carbon fibers aligned in one direction and a cured product of an epoxy resin (N1) and a layer (a12) containing PAN-based carbon fibers aligned in one direction and a cured product of an epoxy resin (N2).
[12] The laminate according to any one of [1] to [11], in which the layer (b1) containing the epoxy resin (S) has a tensile modulus of 3 MPa or more and 12 MPa or less and a tensile strength of 10 MPa or more and 50 MPa or less.
[13] The laminate according to any one of [1] to [12], in which the layer (b2) containing the thermoplastic elastomer (T) has a tensile modulus of 3 MPa or more and 20 MPa or less and a tensile strength of 8 MPa or more and 40 MPa or less.
[14] The laminate according to any one of [1] to [13], in which the second layer (b) is disposed only in a region including a center of the laminate in a thickness direction.
[15] The laminate according to any one of [1] to [14], in which the second layer (b) is a layer made of a resin containing no fiber.
[16] The laminate according to any one of [1] to [15], in which the second layer (b) has a loss tangent (Tan δ) of 0.2 or more at 20°C in an entire frequency range between 100 Hz and 4000 Hz.
[17] The laminate according to any one of [1] to [16], in which the laminate has a loss factor of 0.01 or more.
[18] The laminate according to any one of [1] to [17], in which a time for vibration damping of the laminate to reach 1/4 is 0.7 seconds or less.
[19] The laminate according to any one of [1] to [18], including: a fixed portion configured to be fixed to a transfer device; and a finger portion extending from the fixed portion in a substantially U-shape.
[20] The laminate according to any one of [1] to [19], in which the laminate has a flat plate shape.
[21] The laminate according to any one of [1] to [20], further including a layer (c) containing a woven fabric of glass fibers and a matrix resin on at least one of outermost layers of the laminate.
[22] A transfer hand including the laminate described in any one of [17] to [21].
[23] A transfer device incorporating the transfer hand described in [22].
[24] A semiconductor manufacturing device incorporating the transfer hand described in [22].
[25] A method for manufacturing a laminate, the method including pressurizing a laminate precursor in which first layers (A) are disposed on both surfaces of a second layer (B) to obtain a laminate, in which
   each of the first layers (A) is a layer selected from a carbon fiber prepreg layer (A1), a ceramic layer (A2), and a metallic layer (A3),
   the second layer (B) is a layer selected from a layer (B1)) mainly containing an epoxy resin (S) (provided that a carbon fiber prepreg layer (a1) is excluded), and a layer (B2) mainly containing a thermoplastic elastomer (T), and
   a proportion of a thickness of the second layer (B) to a total thickness of the first layers (A) and the second layer (B) is 0.3% or more and less than 30%.

### Advantageous Effects of Invention

According to the present invention, it is possible to provide a laminate excellent in vibration damping properties and a method for manufacturing the same, a transfer hand, a transfer device, and a semiconductor manufacturing device.

### Brief Description of Drawings

FIG. 1 is a cross-sectional view illustrating an example of a laminate of the present invention.
FIG. 2 is a plan view illustrating the example of the laminate of the present invention.
FIG. 3 is a cross-sectional view illustrating an example of a laminate precursor of the present invention.
FIG. 4 is an explanatory view schematically illustrating an example of a device used for measuring vibration damping properties.
FIG. 5 is a diagram illustrating results of vibration damping properties of a laminate obtained in Example 1.
FIG. 6 is a diagram illustrating results of vibration damping properties of a laminate obtained in Example 2.
FIG. 7 is a diagram illustrating results of vibration damping properties of a laminate obtained in Example 5.
FIG. 8 is a diagram illustrating results of vibration damping properties of a laminate obtained in Example 6.
FIG. 9 is a diagram illustrating results of vibration damping properties of a stainless steel plate used in Example 7.
FIG. 10 is a diagram illustrating results of vibration damping properties of a laminate obtained in Comparative Example 1.
FIG. 11 is a diagram illustrating results of vibration damping properties of a laminate obtained in Comparative Example 2.
FIG. 12 is a diagram illustrating results of vibration damping properties of a stainless steel plate used in Comparative Example 3.
FIG. 13 is a diagram illustrating results of vibration damping properties of an Al-Mg alloy plate used in Comparative Example 4.
FIG. 14 is a diagram illustrating results of vibration damping properties of a ceramic plate used in Comparative Example 5.
FIG. 15 is a diagram illustrating results of vibration damping properties of a ceramic plate used in Comparative Example 6.

### Description of Embodiments

Embodiments of the present invention will be specifically described below, but the present invention is not limited to the following embodiments and can be carried out with various modifications within the scope of the gist of the present invention.

The numerical ranges of the contents, various physical property values, and property values disclosed in the present description can be changed to new numerical ranges by arbitrarily combining the lower limit values and the upper limit values thereof.

In the present invention, the term "epoxy resin" is used for a raw material resin before curing. Since the epoxy group is consumed by a curing reaction, the resin after curing may not have an epoxy group (epoxy structure).

In each drawing used in the following description, to make features thereof easy to understand, portions corresponding to the features are sometimes shown enlarged for the sake of convenience and the dimensional ratios and the like of components may differ from the actual ones.

### Laminate

A laminate according to an embodiment includes a plurality of first layers (a) and a second layer (b), and the first layers (a) are disposed on both surfaces of the second layer (b).

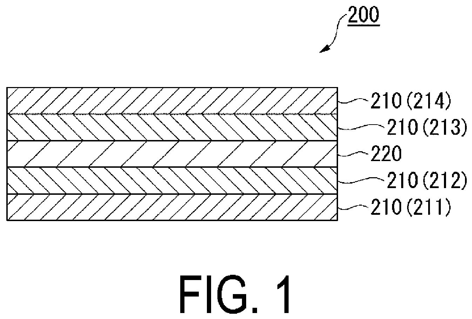

FIG. 1 illustrates an example of the laminate according to the embodiment.

A laminate 200 as the example illustrated in FIG. 1 includes one second layer (b) 220 and a total of four first layers (a) 210 in which two layers are disposed on each of both surfaces of the second layer (b) 220.

### First Layer (a)

Each of the first layers (a) is a layer selected from a carbon fiber-reinforced resin layer (a1) (hereinafter also referred to as "layer (a1)"), a ceramic layer (a2), and a metallic layer (a3).

Examples of the metallic layer (a3) include an aluminum layer, a SUS layer, and a titanium alloy layer.

From the viewpoint of weight reduction, the first layer (a) is preferably the layer (a1).

The layer (a1) is a cured product of a layer (A1) described for the laminate precursor below.

Hereinafter, the carbon fibers used in the layer (a1) are also referred to as "carbon fibers (M)".

The carbon fibers (M) are not particularly limited, and examples thereof include pitch-based carbon fibers such as petroleum-based carbon fibers and coal-based carbon fibers, PAN-based carbon fibers (polyacrylonitrile-based carbon fibers), rayon-based carbon fibers, and lignin-based carbon fibers. From the viewpoint of further improving the vibration damping properties of the laminate, the layer (a1) is preferably a layer containing pitch-based carbon fibers. From the viewpoint of improving strength and reducing a manufacturing cost, the layer (a1) is preferably a layer containing PAN-based carbon fibers.

The layer (a1) preferably includes both a layer containing pitch-based carbon fibers and a layer containing PAN-based carbon fibers.

A tensile modulus of the pitch-based carbon fibers used in the layer (a1) is preferably 600 GPa or more, more preferably 640 GPa or more, and even more preferably 760 GPa or more, and is preferably 800 GPa or less, more preferably 780 GPa or less, and even more preferably 780 GPa or less. When the tensile modulus of the pitch-based carbon fibers is not less than the lower limit value described above, desired deflection performance is likely to be realized. When the tensile modulus of the pitch-based carbon fibers is not greater than the upper limit value described above, vibration more rapidly converges when the laminate vibrates. That is, the vibration damping properties of the laminate are likely to be sufficiently exhibited. The upper limits and the lower limits of the tensile modulus of the pitch-based carbon fibers can be arbitrarily combined, and the tensile modulus can be, for example, from 600 to 800 GPa, from 640 to 780 GPa, or from 760 to 780 GPa.

The tensile modulus of the pitch-based carbon fibers is a value as measured in accordance with JIS R 7601:1986.

A tensile modulus of the PAN-based carbon fibers used in the layer (a1) is preferably 200 GPa or more, more preferably 220 GPa or more, and even more preferably 230 GPa or more, and is preferably 400 GPa or less, more preferably 350 GPa or less, and even more preferably 320 GPa or less. When the tensile modulus of the PAN-based carbon fibers is not less than the lower limit value described above, rigidity of the laminate is improved. When the tensile modulus of the PAN-based carbon fibers is not greater than the upper limit value described above, the manufacturing cost can be reduced. The upper limits and the lower limits of the tensile modulus of the PAN-based carbon fibers can be arbitrarily combined, and the tensile modulus can be, for example, from 200 to 400 GPa, from 220 to 350 GPa, or from 230 to 320 GPa.

The tensile modulus of the PAN-based carbon fibers is measured in the same manner as the tensile modulus of the pitch-based carbon fibers.

The carbon fibers (M) may be continuous fibers or discontinuous fibers, and are preferably continuous fibers.

An average fiber diameter of the carbon fibers (M) is preferably 5 µm or more, more preferably 7 µm or more, and even more preferably 10 µm or more, and is preferably 17 µm or less, more preferably 15 µm or less, and even more preferably 13 µm or less. The upper limits and the lower limits of the average fiber diameter of the carbon fibers (M) can be arbitrarily combined, and the average fiber diameter can be, for example, from 5 to 17 µm, from 7 to 15 µm, or from 10 to 13 µm.

The average fiber diameter of the carbon fibers (M) is a value obtained by taking a photograph of a cross section of the carbon fibers at a magnification of 50 times or more with a microscope such as a scanning electron microscope, randomly selecting 50 single fibers, measuring the diameters thereof, and averaging the diameters. When the cross section of the carbon fiber has a major axis and a minor axis, the major axis is defined as fiber diameter of the fiber.

The carbon fibers (M) are preferably used in the form of a carbon fiber bundle in which a plurality of carbon fibers are bundled.

The number of filaments in the carbon fiber bundle is preferably 3000 or more, more preferably 6000 or more, and even more preferably 12000 or more, and is preferably 24000 or less, more preferably 18000 or less, and even more preferably 15000 or less. When the number of filaments in the carbon fiber bundle is within the above ranges, productivity and mechanical characteristics on an industrial scale are excellent. The upper limits and the lower limits of the number of filaments in the carbon fiber bundle can be arbitrarily combined, and the number of filaments can be, for example, from 3000 to 24000, from 6000 to 18000, or from 12000 to 15000.

A shape of the carbon fibers (M) is not particularly limited, and examples thereof include forms such as fiber bundles such as a chopped strand and a roving, woven fabrics such as a plain weave and a twill weave, knitted fabrics, nonwoven fabrics, fiber paper, sheets (unidirectional materials (UD materials)) in which a plurality of continuous fibers are aligned in one direction, and sheets in which short fibers (bundles) obtained by cutting a continuous fiber to a certain length are randomly deposited. Among these, from the viewpoint of mechanical characteristics such as tensile modulus and tensile strength, the shape of the carbon fibers is preferably a woven fabric, a knitted fabric, or a UD material, and more preferably a UD material.

A basis weight of a carbon fiber base material such as a UD material is preferably 75 g/m² or more, and more preferably 125 g/m² or more, and is preferably 560 g/m² or less, and more preferably 450 g/m² or less. The upper limits and the lower limits of the basis weight of the carbon fiber base material can be arbitrarily combined, and the basis weight can be, for example, from 75 to 560 g/m² or from 125 to 450 g/m².

The layer (a1) may contain additional fibers other than the carbon fibers.

As the additional fibers, for example, inorganic fibers other than the carbon fibers, organic fibers, metal fibers, or reinforced fibers having a hybrid configuration in which these fibers are combined can be used.

Examples of the inorganic fibers other than the carbon fibers include graphite fibers, silicon carbide fibers, alumina fibers, tungsten carbide fibers, boron fibers, and glass fibers.

Examples of the organic fibers include aramid fibers, high-density polyethylene fibers, other general nylon fibers, and polyester fibers.

Examples of the metal fibers include fibers of stainless steel, iron, and the like.

Examples of the reinforced fibers having a hybrid configuration include carbon fibers coated with a metal.

Among these, in consideration of mechanical characteristics such as strength of a prepreg, glass fibers are preferable as the additional fibers.

One of these additional fibers may be used alone, or two or more thereof may be used in any combination and at any ratio.

As the matrix resin constituting the layer (a1), for example, thermosetting resins can be used. Specific examples of the thermosetting resins include epoxy resins, phenol resins, unsaturated imide resins, cyanate resins, isocyanate resins, benzoxazine resins, oxetane resins, amino resins, unsaturated polyester resins, allyl resins, dicyclopentadiene resins, silicone resins, triazine resins, and melamine resins. From the viewpoint of increasing adhesion to the carbon fibers and dynamic properties of a composite material, the matrix resin is preferably an epoxy resin. Hereinafter, the epoxy resin used in the layer (a1) is also referred to as "epoxy resin (N)".

One of these matrix resins may be used alone, or two or more thereof may be used in any combination and at any ratio.

Examples of the epoxy resin (N) include glycidyl ether epoxy resins such as bisphenol A epoxy resins, bisphenol F epoxy resins, bisphenol S epoxy resins, biphenyl epoxy resins, phenol novolac epoxy resins and cresol novolac epoxy resins, glycidyl ester epoxy resins, glycidyl amine epoxy resins, linear aliphatic epoxy resins, alicyclic epoxy resins, and heterocyclic epoxy resins. One of these epoxy resins may be used alone, or two or more thereof may be used in any combination and at any ratio.

The layer (a1) may contain various additives in addition to the fibers and the matrix resin.

Examples of the additives include an antioxidant, an internal mold release agent, a shrinkage reducing agent, a colorant, a flame retardant, and a modifier.

One of these additives may be used alone, or two or more thereof may be used in any combination and at any ratio.

A content of the carbon fibers (hereinafter referred to as "fiber content") per layer (a1) is preferably 45 vol% or more, more preferably 50 vol% or more, and even more preferably 55 vol% or more, and is preferably 75 vol% or less, more preferably 70 vol% or less, and even more preferably 65 vol% or less, relative to a total volume per layer (a1). When the fiber content is not less than the lower limit value described above, the mechanical properties of the laminate are further enhanced. When the fiber content is not greater than the upper limit value described above, adhesion between the carbon fibers (M) and the epoxy resin (N) can be sufficiently ensured. The upper limits and the lower limits of the fiber content per layer (a1) can be arbitrarily combined, and the fiber content can be, for example, from 45 to 75 vol%, from 50 to 70 vol%, or from 55 to 65 vol%.

A content of the epoxy resin (N) (hereinafter, also referred to as "resin content") per layer (a1) is preferably 20 mass% or more, more preferably 25 mass% or more, and even more preferably 30 mass% or more, and is preferably 45 mass% or less, more preferably 40 mass% or less, and even more preferably 35 mass% or less, relative to a total mass per layer (a1). When the resin content is not less than the lower limit value described above, the adhesion between the carbon fibers (M) and the epoxy resin (N) can be sufficiently ensured. When the resin content is not greater than the upper limit value described above, the mechanical properties of the laminate are further enhanced. The upper limits and the lower limits of the resin content per layer (a1) can be arbitrarily combined, and the resin content can be, for example, from 20 to 45 mass%, from 25 to 40 mass%, or from 30 to 35 mass%.

A thickness per layer (a1) is preferably 0.1 mm or more, more preferably 0.15 mm or more, and even more preferably 0.2 mm or more, and is preferably 1.5 mm or less, more preferably 1.0 mm or less, and even more preferably 0.8 mm or less. When the thickness per layer (a1) is not less than the lower limit value described above, a desired thickness can be obtained with a relatively small number of layers. When the thickness per layer (a1) is not greater than the upper limit value described above, the desired thickness can be obtained with a smaller number of layers. The upper limits and the lower limits of the thickness per layer (a1) can be arbitrarily combined, and the thickness can be, for example, from 0.1 to 1.5 mm, from 0.15 to 1.0 mm, or from 0.2 to 0.8 mm.

The thickness (average thickness) of the layer (a1) is measured by observing a cross section of the laminate with a microscope or the like, and is determined by an arithmetic mean thereof.

### Layer Configuration of First Layer (a)

The first layer (a) preferably includes, as the carbon fiber-reinforced resin layer (a1), a layer (a11) containing pitch-based carbon fibers aligned in one direction and a cured product of an epoxy resin (N1).

All of the plurality of first layers (a) may be constituted by the layer (a11), or may have the layer (a11) and a layer other than the layer (a11), and may have, for example, the layer (a11) and a layer (a12) containing PAN-based carbon fibers aligned in one direction and a cured product of an epoxy resin (N2).

The first layer (a) preferably has a layer (hereinafter, also referred to as "layer (β₀)") containing carbon fibers oriented at an orientation angle of 0° when a longitudinal direction of the laminate is defined as 0°, that is, oriented so as to be parallel to the longitudinal direction of the laminate, and a cured product of an epoxy resin.

The layer (β₀) preferably includes at least one of the layer (a11) and the layer (a12), more preferably includes at least the layer (a11), and even more preferably is the layer (a11). When the layer (β₀) includes the layer (a11), the vibration damping properties of the laminate are further improved.

In the present invention, the layer (a11) in which the orientation angle of the pitch-based carbon fibers is 0° is particularly referred to as "layer (a11₀)", and the layer (a12) in which the orientation angle of the PAN-based carbon fibers is 0° is particularly referred to as "layer (a12₀)".

One type of the layer (β₀) may be used, or two or more types thereof may be used.

The plurality of first layers (a) preferably have a layer (β₀) and a layer (β) containing carbon fibers oriented at an orientation angle of 45° or more and 90° or less relative to orientation of the carbon fibers contained in the layer (β₀). That is, the plurality of first layers (a) preferably have two or more layers having different orientation angles of the carbon fibers, specifically, the layer (β₀) and the layer (β), and more preferably have the layer (a11₀) and the layer (β).

Since the plurality of first layers (a) have the layer (β₀) and the layer (β), it is possible to prevent a crack in the laminate while improving the vibration damping properties of the laminate.

In a case where the plurality of first layers (a) have the layer (β₀) and the layer (β), the layer (β₀) is preferably positioned closer to an outermost layer side of the laminate than the layer (β).

The layer (β) preferably includes at least one of the layer (a11) and the layer (a12).

In particular, from the viewpoint of suppressing the deflection in a direction of 45° or more and 90° or less relative to the orientation of the carbon fibers contained in the layer (β₀), the layer (β) is preferably the layer (a11). When the layer (β₀) and the layer (β) are the layers (a11), the epoxy resin (N1) used for the layer (a11₀) that is the layer (β₀) and the epoxy resin (N1) used for the layer (a11) that is the layer (β) may be the same type or different types.

From the viewpoint of increasing strength of the laminate and reducing the manufacturing cost, the layer (β) is preferably the layer (a12).

One type of the layer (β) may be used, or two or more types thereof may be used.

An orientation angle (θ) of the carbon fibers contained in the layer (β) is 45° or more and 90° or less, preferably 45°, 60° or 90°, more preferably 45° or 90°, and particularly preferably 90°, when the orientation angle (θ₀) of the carbon fibers contained in the layer (β₀) is defined as 0°.

In the present description, the layer containing carbon fibers aligned in one direction so that the orientation angle (θ) is 90° and a cured product of an epoxy resin is referred to as "layer (β₉₀)". In particular, the case where the pitch-based carbon fibers are included as the carbon fibers is also referred to as "layer (a11₉₀)", and the case where the PAN-based carbon fibers are included as the carbon fibers is also referred to as "layer (a12₉₀)". The other orientation angles (θ) are also expressed in the same manner.

Examples of the configuration of the plurality of first layers (a) include combinations as indicated below.
· Combination of layer (a11₀) and layer (a11₉₀).
· Combination of layer (a11₀) and layer (a12₉₀).
· Combination of layer (a11₀), layer (a11₉₀), and layer (a12₉₀).
· Combination of layer (a11₀) and layer (a11₄₅).
· Combination of layer (a11₀) and layer (a12₄₅).
· Combination of layer (a11₀), layer (a11₄₅), and layer (a12₄₅).
· Combination of layer (a11₀) and layer (a11₆₀).
· Combination of layer (a11₀) and layer (a12₆₀).
· Combination of layer (a11₀), layer (a11₆₀), and layer (a12₆₀).
· Combination of layer (a11₀), layer (a11₉₀), and layer (a11₄₅).
· Combination of layer (a11₀), layer (a12₉₀), and layer (a12₄₅).
· Combination of layer (a11₀), layer (a11₉₀), and layer (a12₄₅).
· Combination of layer (a11₀), layer (a12₉₀), and layer (a11₄₅).
· Combination of layer (a12₀) and layer (a12₉₀).

The laminate preferably has a symmetric laminate structure from the viewpoint of suppressing warpage during processing. Therefore, for example, in the case of the laminate 200 illustrated in FIG. 1, when the four first layers (a) 210 are referred to as first a layer 211, second a layer 212, third a layer 213, and fourth a layer 214 in order from the bottom, the first a layer 211 and the fourth a layer 214 are preferably the same layers (a1), and the second a layer 212 and the third a layer 213 are preferably the same layers (a1). In a case where the plurality of first layers (a) 210 have the layer (β₀), at least the first a layer 211 and the fourth a layer 214 are preferably the layers (β₀), and more preferably the layers (a11₀).

Here, the term "the same" means that the layers (a1) have the same configuration, and also have the same thickness and the same orientation angle of the carbon fibers.

### Other Forms

When the first layer (a) is either the ceramic layer (a2) or the metallic layer (a3), examples of the configuration of the plurality of first layers (a) include combinations as indicated below.
· Combination of ceramic layer (a2) and ceramic layer (a2).
· Combination of aluminum layer and aluminum layer.
· Combination of SUS layer and SUS layer.
· Combination of titanium alloy layer and titanium alloy layer.

Thicknesses per ceramic layer (a2) and per metallic layer (a3) are each preferably 0.4 mm or more, and more preferably 0.6 mm or more, and are preferably 1.5 mm or less, and more preferably 1.0 mm or less. When the thickness per layer described above is not less than the lower limit value described above, a desired thickness can be obtained with a relatively small number of layers. When the thickness per layer described above is not greater than the upper limit value described above, the desired thickness can be obtained with a smaller number of layers. The upper limits and the lower limits of the thickness per ceramic layer (a2) or metallic layer (a3) can be arbitrarily combined, and the thickness can be, for example, from 0.4 to 1.5 mm or from 0.6 to 1.0 mm.

The thickness (average thickness) of each of the ceramic layer (A2) and the metallic layer (a3) is measured by observing the cross section of the laminate with a microscope or the like, and is determined by an arithmetic mean thereof.

### Second Layer (b)

The second layer (b) 220 in the example illustrated in FIG. 1 is positioned in the middle of the four first layers (a). The "middle" referred to herein is a center (middle) of the laminate 200 in a thickness direction (lamination direction), and, in the example illustrated in FIG. 1, is between the second a layer 212 and the third a layer 213. That is, the second layer (b) 220 in the example illustrated in FIG. 1 is an intermediate layer of the laminate 200, and is disposed only in a region including the center of the laminate 200 in the thickness direction.

The second layer (b) is a layer selected from a layer (b1) mainly containing an epoxy resin (S) (provided that the carbon fiber-reinforced resin layer (a1) is excluded; hereinafter, also referred to as "layer (b1)") and a layer (b2) mainly containing a thermoplastic elastomer (T) (hereinafter, also simply referred to as "layer (b2)").

From the viewpoint of a vibration damping effect, the second layer (b) is preferably the layer (b1).

The layer (b1) and the layer (b2) in the present embodiment are the same as the layer (B1) and the layer (B2), respectively, described for the laminate precursor described later.

The second layer (b) is preferably a layer made of a resin containing no fiber.

### Layer (b1)

The layer (b1) is a layer (epoxy resin layer) mainly containing an epoxy resin (S). However, the phrase "mainly containing an epoxy resin (S)" means that a proportion of the epoxy resin (S) to a total mass of the layer (b1) is 50 mass% or more.

The proportion of the epoxy resin (S) to the total mass of the layer (b1) is preferably 70 mass% or more, and more preferably 90 mass% or more.

The layer (b1) may further contain a component other than the epoxy resin (S) (hereinafter, also referred to as "additional component") in addition to the epoxy resin (S) as long as the effects of the present invention are not impaired.

The layer (b1) is preferably a sheet or film of the epoxy resin (S).

In general, the term "sheet" refers to a thin and flat product having a thickness small for the length and width thereof according to the definition of JIS. In general, the term "film" refers to a thin and flat product having a thickness that is extremely small as compared with the length and width thereof, with the maximum thickness being optionally limited, and usually refers to a product that is supplied in the form of a roll (JIS K 6900:1994). However, the boundary between the "sheet" and the "film" is unclear, and it is not necessary to distinguish between the two in the wording in the present description. Therefore, in the present description, when a product is referred to as "film", the product is also intended to include a "sheet", and when a product is referred to as "sheet", the product is also intended to include a "film".

### Physical Properties

An elongation at break of the layer (b1) is preferably 100% or more, and more preferably 200% or more, and is preferably 500% or less, and more preferably 400% or less. When the elongation at break of the layer (b1) is not less than the lower limit value described above, the vibration damping properties of the laminate are further improved. When the elongation at break of the layer (b1) is not greater than the upper limit value, the rigidity of the laminate is further improved. The upper limits and the lower limits of the elongation at break of the layer (b1) can be arbitrarily combined, and the elongation at break can be set to, for example, from 100 to 500% or from 200 to 400%.

The elongation at break of the layer (b1) can be determined as follows. The layers other than the layer (b1) are shaved off from the laminate; the laminate is cut into a 10 mm wide × 50 mm long test piece; a tensile test is performed at a test speed of 200 mm/min in an environment of 23°C and 50% RH in accordance with JIS K 7127:1999; and the elongation at tensile break is measured.

A tensile modulus of the layer (b1) is preferably 3 MPa or more, more preferably 3.5 MPa or more, and even more preferably 4 MPa or more, and is preferably 12 MPa or less, more preferably 10 MPa or less, and even more preferably 8 MPa or less. When the tensile modulus of the layer (b1) is not less than the lower limit value described above, the rigidity of the laminate is further improved. When the tensile modulus of the layer (b1) is not greater than the upper limit value described above, the vibration damping properties of the laminate are further improved. The upper limits and the lower limits of the tensile modulus of the layer (b1) can be arbitrarily combined, and the tensile modulus can be, for example, from 3 to 12 MPa, from 3.5 to 10 MPa, or from 4 to 8 MPa.

The tensile modulus of the layer (b1) can be determined as follows. That is, the layers other than the layer (b1) are shaved off from the laminate; the laminate is cut into a 10 mm wide × 50 mm long test piece; and the tensile modulus of the test piece is measured by the dynamic viscoelasticity measurement method described in JIS K 7244-4:1999 using a dynamic viscoelasticity measuring device (for example, product name "DVA-200" available from IT Keisoku Seigyo K. K.) under measuring conditions of a frequency of 1 Hz, a temperature rising rate of 3°C/min, and a double-supported tensile mode.

A tensile strength of the layer (b1) is preferably 10 MPa or more, more preferably 15 MPa or more, and even more preferably 20 MPa or more, and is preferably 50 MPa or less, more preferably 45 MPa or less, and even more preferably 40 MPa or less. When the tensile strength of the layer (b1) is not less than the lower limit value described above, the rigidity of the laminate is further improved. When the tensile strength of the layer (b1) is not greater than the upper limit value described above, the vibration damping properties of the laminate are further improved. The upper limits and the lower limits of the tensile strength of the layer (b1) can be arbitrarily combined, and the tensile strength can be, for example, from 10 to 50 MPa, from 15 to 45 MPa, or from 20 to 40 MPa.

The tensile strength of the layer (b1) can be determined as follows. That is, the layers other than the layer (b1) are shaved off from the laminate; the laminate is cut into a 10 mm wide × 50 mm long test piece; and the tensile strength of the test piece is measured by the dynamic viscoelasticity measurement method described in JIS K 7244-4:1999 using a dynamic viscoelasticity measuring device (for example, product name "DVA-200" available from IT Keisoku Seigyo K. K.) under measuring conditions of a frequency of 1 Hz, a temperature rising rate of 3°C/min, and a double-supported tensile mode.

### Epoxy Resin (S)

The epoxy resin (S) is not particularly limited as long as the epoxy resin (S) is an epoxy resin that allows the layer (b1) to have an elongation at break of 100% or more and 500% or less, but is preferably an epoxy resin different from the epoxy resin (N).

The epoxy resin (S) is preferably an epoxy resin having stretchability (hereinafter, also referred to as "stretchable epoxy resin").

Here, the term "epoxy resin having stretchability" refers to, for example, a stretchable epoxy resin sheet or film that can be visually observed to stretch or shrink when pulled by hand.

The stretchable epoxy resin can be obtained by, for example, thermally curing a stretchable epoxy resin composition containing a chemical structure having stretchability. More specifically, the stretchable epoxy resin can be obtained by thermally curing a stretchable epoxy resin composition containing a main agent containing an epoxy resin having a chemical structure that becomes a stretchable epoxy resin having stretchability after curing, and a curing agent. Alternatively, as another method, the stretchable epoxy resin can be obtained by curing a resin raw material that becomes a stretchable epoxy resin after curing, with radiation such as γ-rays, electron beams, or X-rays.

The stretchable epoxy resin is more preferably an epoxy resin having a block structure of a rigid component and a flexible component (hereinafter, also referred to as "epoxy resin (S1)"). By having such a structure, the epoxy resin is likely to have excellent stretchability.

The stretchable epoxy resin can be obtained by curing a stretchable epoxy resin composition containing a main agent and a curing agent, for example.

Hereinafter, the stretchable epoxy resin composition before curing will be described.

The stretchable epoxy resin composition preferably contains a stretchable epoxy resin as the main agent, and more preferably contains an epoxy resin (S1).

The rigid component of the epoxy resin (S1) preferably contains ring structures having aromaticity, for example, condensed aromatic ring structures such as benzene rings, naphthalene rings, anthracene rings, and pyrene rings, structures containing a large number of aromatic ring structures such as biphenol rings, cardo structures, and fluorene rings, and heterocyclic structures such as pyrrole rings and thiophene rings.

The flexible component of the epoxy resin (S1) preferably contains aliphatic hydrocarbyl groups, for example alkylene groups having from 1 to 8 carbon atoms, ethylene glycol groups, propylene glycol groups, and/or butylene glycol groups.

When the stretchable epoxy resin composition contains such an epoxy resin (S1), flexibility tends to be easily imparted to a cured product of the layer (b1).

The epoxy resin (S1) does not necessarily have an epoxy group or a structure derived from an epoxy group in both the rigid component and the flexible component. That is, the epoxy resin (S1) only needs to have an epoxy group or a structure derived from an epoxy group in at least one of the rigid component and the flexible component. From the viewpoint of imparting flexibility while maintaining the properties inherent in epoxy resins, such as excellent heat resistance and mechanical strength, it is preferable that only one of the rigid component and the flexible component should have an epoxy group or a structure derived from an epoxy group.

Examples of the epoxy resin (S1) include copolymers of bisphenol F and 1,6-hexanediol diglycidyl ether, copolymers of 1,6-hexanediol and bisphenol F diglycidyl ether, copolymers of bisphenol F and 1,4-butanediol diglycidyl ether, copolymers of 1,4-butanediol and bisphenol F diglycidyl ether, copolymers of bisphenol A and 1,6-hexanediol diglycidyl ether, copolymers of 1,6-hexanediol and bisphenol A diglycidyl ether, copolymers of bisphenol A and 1,4-butanediol diglycidyl ether, copolymers of 1,4-butanediol and bisphenol A diglycidyl ether, copolymers of tetramethylbiphenol and 1,6-hexanediol diglycidyl ether, copolymers of 1,6-hexanediol and tetramethylbiphenol diglycidyl ether, copolymers of tetramethylbiphenol and 1,4-butanediol diglycidyl ether, copolymers of 1,4-butanediol and tetramethylbiphenol diglycidyl ether, copolymers of biphenol and 1,6-hexanediol diglycidyl ether, copolymers of 1,6-hexanediol and biphenol diglycidyl ether, copolymers of biphenol and 1,4-butanediol diglycidyl ether, copolymers of 1,4-butanediol and biphenol diglycidyl ether, copolymers of 1,4-naphthalenediol and 1,6-hexanediol diglycidyl ether, copolymers of 1,6-hexanediol and 1,4-naphthalenediol diglycidyl ether, copolymers of 1,4-naphthalenediol and 1,4-butanediol diglycidyl ether, copolymers of 1,4-butanediol and 1,4-naphthalenediol diglycidyl ether, copolymers of 1,6-naphthalenediol and 1,6-hexanediol diglycidyl ether, copolymers of 1,6-hexanediol and 1,6-naphthalenediol diglycidyl ether, copolymers of 1,6-naphthalenediol and 1,4-butanediol diglycidyl ether, and copolymers of 1,4-butanediol and 1,6-naphthalenediol diglycidyl ether. From the viewpoint of imparting flexibility, the epoxy resin (S1) preferably includes copolymers of bisphenol F and 1,6-hexanediol diglycidyl ether.

One of these epoxy resins (S1) may be used alone, or two or more thereof may be used in any combination and at any ratio.

The stretchable epoxy resin composition may further contain, as necessary, an epoxy resin other than the epoxy resin (S1) (hereinafter, also referred to as "additional epoxy resin (S2)") in addition to the epoxy resin (S1) as the main agent.

Examples of the additional epoxy resin (S2) include the epoxy resin (N) described above.

The stretchable epoxy resin composition may be either a composition containing only the epoxy resin (S1) as the main agent or a composition containing the epoxy resin (S1) and an additional epoxy resin (S2) as the main agent.

When the stretchable epoxy resin composition contains the epoxy resin (S1) and the additional epoxy resin (S2), a content of the epoxy resin (S1) relative to a total mass of all the epoxy components as the solid content in the stretchable epoxy resin composition is preferably 50 mass% or more and 99 mass% or less.

Here, the term "solid content" means components excluding a solvent, and includes not only a solid epoxy resin or epoxy compound but also a semi-solid or viscous liquid. The term "all the epoxy components" means a total of the epoxy resin (S1) and the additional epoxy resin (S2).

The curing agent contained in the stretchable epoxy resin composition is a curing agent that contributes to a crosslinking reaction between the epoxy group of the epoxy resin (S1) and the group having reactivity with the epoxy group.

The curing agent is not particularly limited, and all curing agents generally known as epoxy resin curing agents can be used. Examples of the curing agent include phenolic curing agents, aliphatic amines, polyether amines, alicyclic amines, amine-based curing agents such as aromatic amines, acid anhydride-based curing agents, amide-based curing agents, tertiary amines, imidazole and derivatives thereof, organic phosphines, phosphonium salts, tetraphenylboron salts, organic acid dihydrazide, halogenated boron amine complexes, polymercaptan-based curing agents, isocyanate-based curing agents, and blocked isocyanate-based curing agents. Among these, from the viewpoint of high transparency and less coloration, a curing agent having an alicyclic structure is preferable as the curing agent.

One of these curing agents may be used alone, or two or more thereof may be used in any combination and at any ratio.

The curing agent having an alicyclic structure only needs to be a substance having an alicyclic structure and contributing to at least one of a crosslinking reaction and a chain extension reaction between epoxy groups of the epoxy resin (S). Specific examples of the substance include alicyclic polyamines and alicyclic anhydrides. More specifically, examples of the alicyclic polyamine include 1,4-diazabicyclo[2.2.2]octane, 1,8-diazabicyclo[5.4.0]undec-7-ene, N,N'-dimethylpiperazine, N-aminoethylpiperazine, menthenediamine, isophoronediamine, hexamethylenetetramine, methylenebis(cyclohexanamine), 1,3-bis(aminomethyl)cyclohexane, norbornenediamine, 1,2-diaminocyclohexane, and modified alicyclic polyamines obtained by epoxy-modification, ethylene oxide-modification, dimer acid-modification, Mannichmodification, Michael addition, thiourea condensation, or ketiminization of these alicyclic polyamines. Examples of the alicyclic anhydrides include hexahydrophthalic anhydride and methylhexahydrophthalic anhydride. Among these, alicyclic polyamines are preferred, and among these, isophoronediamine, hexamethylenetetramine, methylenebis(cyclohexanamine), 1,3-bis(aminomethyl)cyclohexane, norbornenediamine, 1,2-diaminocyclohexane, and modified products thereof are particularly preferred.

As the curing agent having an alicyclic structure, a commercially available product can also be used, and examples thereof include trade names "jER Cure 113" and "jER Cure ST-14" available from Mitsubishi Chemical Corporation; and trade name "Rikacid MH-700" available from New Japan Chemical Co., Ltd.

A content of the curing agent in the stretchable epoxy resin composition is preferably 0.1 parts by mass or more, more preferably 1 part by mass or more, even more preferably 3 parts by mass or more, and particularly preferably 5 parts by mass or more, and is preferably 100 parts by mass or less, more preferably 80 parts by mass or less, even more preferably 60 parts by mass or less, and particularly preferably 40 parts by mass or less, relative to 100 parts by mass of all the epoxy resin components (total content of all the epoxy components) contained in the stretchable epoxy resin composition. The upper limits and the lower limits of the content of the curing agent can be arbitrarily combined, and the content can be, for example, from 0.1 to 100 parts by mass, from 1 to 80 parts by mass, from 3 to 60 parts by mass, or from 5 to 40 parts by mass.

In order to appropriately adjust the viscosity during handling in forming the layer (b1), a solvent may be blended in the stretchable epoxy resin composition to dilute the composition. The solvent is used to ensure handleability and workability in the formation of the layer (b1), and an amount thereof used is not particularly limited.

Examples of the solvent include acetone, methyl ethyl ketone, toluene, xylene, methyl isobutyl ketone, ethyl acetate, ethylene glycol monomethyl ether, N,N-dimethylformamide, N,N-dimethylacetamide, methanol, and ethanol.

One of these solvents may be used alone, or two or more thereof may be used in any combination and at any ratio.

The stretchable epoxy resin composition may contain an additional component in addition to the main agent and the curing agent.

The additional components can be used in combination as appropriate depending on desired physical properties of the stretchable epoxy resin composition.

Examples of the additional components include inorganic fillers (for example, powdery inorganic reinforcing agent, inorganic filler, and the like), organic fillers (for example, rubber particles, acrylic particles, and the like), coupling agents, plasticizers, diluents, flexibilityimparting agents, dispersants, wetting agents, colorants, pigments, ultraviolet absorbers, light stabilizers such as hindered amine-based light stabilizers, antioxidants, defoamers, mold release agents, and flow control agents.

One of these additional components may be used alone, or two or more thereof may be used in any combination and at any ratio.

### Layer (b2)

The layer (b2) is a layer mainly containing a thermoplastic elastomer (T). However, the phrase "mainly containing a thermoplastic elastomer (T)" means that a proportion of the thermoplastic elastomer (T) to a total mass of the layer (b2) is 50 mass% or more.

The proportion of the thermoplastic elastomer (T) to the total mass of the layer (b2) is preferably 70 mass% or more, and more preferably 90 mass% or more.

In addition to the thermoplastic elastomer (T), the layer (b2) may further contain a component other than the thermoplastic elastomer (T) (hereinafter, also referred to as "additional component") as necessary as long as the effects of the present invention are not impaired.

The layer (b2) is preferably a sheet or film of the thermoplastic elastomer (T).

### Physical Properties

An elongation at break of the layer (b2) is preferably 800% or more, and preferably 900% or more, and is preferably 1200% or less, and more preferably 1100% or less. When the elongation at break of the layer (b2) is not less than the lower limit value described above, the vibration damping properties of the laminate are further improved. When the elongation at break of the layer (b2) is not greater than the upper limit value described above, the rigidity of the laminate is further improved. The upper limits and the lower limits of the elongation at break of the layer (b2) can be arbitrarily combined, and the elongation at break can be set to, for example, from 800 to 1200% or from 900 to 1100%.

The elongation at break of the layer (b2) can be determined as follows. The layers other than the layer (b2) are shaved off from the laminate; the laminate is cut into a 10 mm wide × 50 mm long test piece; a tensile test is performed at a test speed of 200 mm/min in an environment of 23°C and 50% RH in accordance with JIS K 7127:1999; and the elongation at tensile break is measured.

A tensile modulus of the layer (b2) is preferably 3 MPa or more, more preferably 3.5 MPa or more, and even more preferably 4 MPa or more, and is preferably 20 MPa or less, more preferably 15 MPa or less, and even more preferably 10 MPa or less. When the tensile modulus of the layer (b2) is not less than the lower limit value described above, the rigidity of the laminate is further improved. When the tensile modulus of the layer (b2) is not greater than the upper limit value described above, the vibration damping properties of the laminate are further improved. The upper limits and the lower limits of the tensile modulus of the layer (b2) can be arbitrarily combined, and the tensile modulus can be, for example, from 3 to 20 MPa, from 3.5 to 15 MPa, or from 4 to 10 MPa.

The tensile modulus of the layer (b2) can be determined as follows. That is, the layers other than the layer (b2) are shaved off from the laminate; the laminate is cut into a 10 mm wide × 50 mm long test piece; and the tensile modulus of the test piece is measured by the dynamic viscoelasticity measurement method described in JIS K 7244-4:1999 using a dynamic viscoelasticity measuring device (for example, product name "DVA-200" available from IT Keisoku Seigyo K. K.) under measuring conditions of a frequency of 1 Hz, a temperature rising rate of 3°C/min, and a double-supported tensile mode.

A tensile strength of the layer (b2) is preferably 8 MPa or more, more preferably 9 MPa or more, and even more preferably 10 MPa or more, and is preferably 40 MPa or less, more preferably 35 MPa or less, and even more preferably 30 MPa or less. When the tensile strength of the layer (b2) is not less than the lower limit value described above, the rigidity of the laminate is further improved. When the tensile strength of the layer (b2) is not greater than the upper limit value described above, the vibration damping properties of the laminate are further improved. The upper limits and the lower limits of the tensile strength of the layer (b2) can be arbitrarily combined, and the tensile strength can be, for example, from 8 to 40 MPa, from 9 to 35 MPa, or from 10 to 30 MPa.

The tensile strength of the layer (b2) can be determined as follows. The layers other than the layer (b2) are shaved off from the laminate; the laminate is cut into a 10 mm wide × 50 mm long test piece; and the tensile strength of the test piece is measured by the dynamic viscoelasticity measurement method described in JIS K 7244-4:1999 using a dynamic viscoelasticity measuring device (for example, product name "DVA-200" available from IT Keisoku Seigyo K. K.) under measuring conditions of a frequency of 1 Hz, a temperature rising rate of 3°C/min, and a double-supported tensile mode.

### Thermoplastic Elastomer (T)

The thermoplastic elastomer (T) is not particularly limited as long as the elongation at break of the layer (b2) is 800% or more and 1200% or less. Examples of the thermoplastic elastomer (T) include styrene-based thermoplastic elastomers, olefin-based thermoplastic elastomers, urethane-based thermoplastic elastomers, vinyl chloride-based thermoplastic elastomers, ester-based thermoplastic elastomers, amide-based thermoplastic elastomers, silicone-based thermoplastic elastomers, and acrylic thermoplastic elastomers. As the thermoplastic elastomer (T), a styrene-based thermoplastic elastomer, an olefin-based thermoplastic elastomer, and a urethane-based thermoplastic elastomer are preferable.

One of these thermoplastic elastomers (T) may be used alone, or two or more thereof may be used in any combination and at any ratio.

Examples of the styrene-based thermoplastic elastomer include a styrene-butadiene-styrene copolymer (SBS), a styrene-isoprene-styrene copolymer (SIS), a styrene-ethylene·butene copolymer (SEB), a styrene-ethylene propylene copolymer (SEP), a styrene-ethylene butenestyrene copolymer (SEBS), a styrene-ethylene propylene-styrene copolymer (SEPS), a styrene-ethylene ethylene propylene-styrene copolymer (SEEPS), a styrene-butadiene butylene-styrene copolymer (partially hydrogenated product of styrene-butadiene-styrene copolymer: SBBS), a partially hydrogenated product of a styrene-isoprene-styrene copolymer, and a partially hydrogenated product of a styrene-isoprene butadiene-styrene copolymer. The symbol "-" indicates that monomers forming units connected by "-" are copolymerized, and " " indicates that the units are present in a state of being randomly modified by hydrogenation or the like after copolymerization.

One of these styrene-based thermoplastic elastomers may be used alone, or two or more thereof may be used in any combination and at any ratio.

Examples of the olefin-based thermoplastic elastomer include ethylene-propylene rubber, ethylene-propylene-diene rubber, an ethylene-vinyl acetate copolymer, butyl rubber, butadiene rubber, a propylene-butene copolymer, and an ethylene-acrylic acid ester copolymer.

One of these olefin-based thermoplastic elastomers may be used alone, or two or more thereof may be used in any combination and at any ratio.

Examples of the urethane-based thermoplastic elastomer include a reaction product of a polymer diol, an organic diisocyanate, and a chain extender.

Examples of the polymer diol include polyester diol, polyether diol, polyester ether diol, polycarbonate diol, and polyester polycarbonate diol.

Examples of the organic diisocyanate include 4,4'-diphenylmethane diisocyanate, toluene diisocyanate, p-phenylene diisocyanate, xylylene diisocyanate, naphthalene diisocyanate, hydrogenated 4,4'-diphenylmethane diisocyanate (4,4'-dicyclohexylmethane diisocyanate), isophorone diisocyanate, and hexamethylene diisocyanate.

Examples of the chain extender include ethylene glycol, diethylene glycol, 1,4-butanediol, 1,5-pentanediol, 2-methyl-1,3-propanediol, 1,6-hexanediol, neopentyl glycol, 1,9-nonanediol, cyclohexanediol, and 1,4-bis(β-hydroxyethoxy)benzene.

One of these urethane-based thermoplastic elastomers may be used alone, or two or more thereof may be used in any combination and at any ratio.

### Additional Component

Examples of the additional component include the additional components exemplified in the description of the layer (b1).

### Thickness

A proportion of a thickness of the second layer (b) is 0.3% or more and less than 30% relative to a total thickness of the first layers (a) and the second layer (b). When the proportion of the thickness of the second layer (b) is not less than the lower limit value described above, sufficient vibration damping performance can be expected to be exhibited. When the proportion of the thickness of the second layer (b) is less than the upper limit value, the influence on the deflection performance under load can be further suppressed. The proportion of the thickness of the second layer (b) is preferably 1% or more, and more preferably 3% or more. The proportion of the thickness of the second layer (b) is preferably 20% or less, and more preferably 10% or less. The upper limits and the lower limits of the proportion of the thickness of the second layer (b) can be arbitrarily combined, and the thickness can be, for example, from 1 to 20% or from 3 to 10%.

The thickness (average thickness) of the first layer (a) and the thickness (average thickness) of the second layer (b) are measured by observing the cross section of the laminate with a microscope or the like, and are determined by arithmetic means thereof.

The thickness of the second layer (b) is preferably 0.03 mm or more, more preferably 0.05 mm or more, and even more preferably 0.1 mm or more, and is preferably 0.5 mm or less, more preferably 0.5 mm or less, and even more preferably 0.4 mm or less. The thickness of the second layer (b) is preferably as small as possible as long as the desired vibration damping effect can be obtained. When the thickness of the second layer (b) is not less than the lower limit value described above, the vibration damping properties of the laminate are improved. When the thickness of the second layer (b) is not greater than the upper limit value described above, the influence on the deflection performance under load can be suppressed. The upper limits and the lower limits of the thickness of the second layer (b) can be arbitrarily combined, and the thickness can be, for example, from 0.03 to 0.5 mm, from 0.05 to 0.5 mm, or from 0.1 to 0.4 mm.

### Loss Factor

A loss tangent (Tan δ) of the second layer (b) is preferably 0.2 or more, and more preferably 0.3 or more at 20°C in an entire frequency range between 100 Hz and 4000 Hz. When the loss tangent (Tan δ) of the second layer (b) is not less than the lower limit value described above, sufficient vibration damping properties can be imparted.

The loss tangent (Tan δ) of the second layer (b) can be determined as follows. The layers other than the second layer (b) are shaved off from the laminate; the laminate is cut into a 10 mm wide × 50 mm long test piece; a storage modulus and a loss modulus are measured using a viscoelasticity measuring machine (for example, product name "Model MCR301" available from Anton Paar GmbH), whose measurement mode is set to a torsion mode under a nitrogen atmosphere at -20°C, -10°C, 0°C, 10°C, and 20°C, a frequency of from 0.1 to 25.1 Hz, and a strain of 0.1%; and a ratio of loss modulus/storage modulus is determined and defined as the loss tangent (Tan δ).

### Physical Properties of Laminate

The loss factor of the laminate is preferably 0.01 or more, more preferably 0.01 or more, and even more preferably 0.01 or more, and is preferably 0.20 or less, more preferably 0.15 or less, and even more preferably 0.10 or less. When the loss factor of the laminate is not less than the lower limit value described above, vibration more rapidly converges when the laminate vibrates. That is, the vibration damping properties of the laminate are further improved. When the loss factor of the laminate is not greater than the upper limit value described above, the desired vibration damping performance can be expected to be exhibited. The upper limits and the lower limits of the loss factor of the laminate can be arbitrarily combined, and the loss factor can be, for example, from 0.01 to 0.20, from 0.01 to 0.15, or from 0.01 to 0.10.

The loss factor of the laminate can be determined from a damped free vibration waveform by the one end fixed impact vibration method in accordance with JIS G 0602:1993.

A time until vibration damping of the laminate reaches 1/4 is preferably 0.7 seconds or less, more preferably 0.5 seconds or less, and even more preferably 0.3 seconds or less. The time until the vibration damping of the laminate reaches 1/4 is preferably as short as possible, and a lower limit value thereof is not particularly limited, but is, for example, 0.01 seconds. The upper limits and the lower limits of the time until the vibration damping of the laminate reaches 1/4 can be arbitrarily combined, and the time can be, for example, from 0.01 to 0.7 seconds, from 0.01 to 0.5 seconds, or from 0.01 to 0.3 seconds.

The time until the vibration damping of the laminate reaches 1/4 is determined by measuring a time waveform of vibration displacement by the one end fixed impact vibration method in accordance with JIS G 0602:1993 and measuring a time until amplitude reaches 1/4 from an initial stage.

A total thickness of the laminate is preferably 1.5 mm or more, and more preferably 2 mm or more, and is preferably 20 mm or less, more preferably 5 mm or less, and even more preferably 4 mm or less. When the total thickness of the laminate is not less than the lower limit value described above, the laminate can be used as a transfer member (transfer base material) having deflection performance. When the total thickness of the laminate is not greater than the upper limit value described above, the laminate can be used as a transfer member because the laminate has a desired mass or less. The upper limits and the lower limits of the total thickness of the laminate can be arbitrarily combined, and the total thickness can be, for example, from 1.5 to 20 mm, from 1 to 5 mm, or from 2 to 4 mm.

The total thickness (average thickness) of the laminate is measured by observing the cross section of the laminate with a microscope or the like, and is determined by an arithmetic mean thereof.

### Shape of Laminate

A shape of the laminate is not particularly limited, and examples thereof include a flat plate shape, a hollow prismatic shape, and a hollow cylindrical shape. The shape of the laminate is preferably a flat plate shape from the viewpoint of easy punching of the laminate into a desired shape.

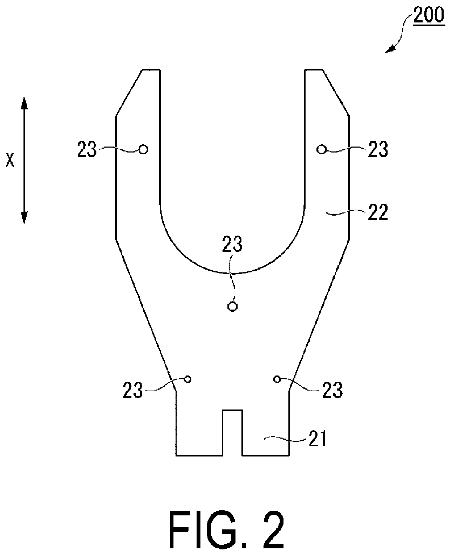

When the laminate is used for a transfer member such as a transfer hand, the laminate preferably has a fixed portion 21 which is configured to be fixed to a transfer device and a finger portion 22 extending from the fixed portion 21 in a substantially U-shape, for example, as illustrated in FIG. 2.

The fixed portion 21 is connected to a transfer device such as a robot hand.

A semiconductor wafer or the like is placed on the finger portion 22.

The fixed portion 21 and the finger portion 22 may be provided with a plurality of through holes 23 penetrating in the lamination direction of the laminate 200.

The "substantially U-shape" is not limited to the U-shape as long as the tip is branched into two in plan view, and includes, for example, a V-shape. The tip is preferably branched in the same direction.

When the plurality of first layers (a) constituting the laminate 200 are the layers (a1) and the plurality of first layers (a) have the layer (a11), an orientation direction of the pitch-based carbon fibers contained in the layer (a11) is preferably an extension direction of the finger portion 22 (X direction in FIG. 2). In particular, it is more preferable that the orientation direction of the pitch-based carbon fibers contained in the layer (a11₀) should be the extension direction of the finger portion 22 (X direction). With such a configuration, the vibration damping properties of the laminate 200 are further improved.

### Operation Effects

The laminate of the present embodiment described above has excellent vibration damping properties because the first layers (a) described above are disposed on both surfaces of the second layer (b) and a proportion of a thickness of the second layer (b) is controlled to fall within a specific range.

The laminate of the present embodiment is excellent in vibration damping properties, and therefore is suitable as a transfer member (transfer base material) such as a transfer hand or a transfer arm. In particular, when the laminate has a flat plate shape, the laminate is suitable as a transfer hand. When the laminate has a hollow prismatic shape or a hollow cylindrical shape, the laminate is suitable as a transfer arm.

In the present invention, the transfer hand includes a fork, a pick, and an end effector.

When the laminate is used for a transfer member such as a transfer hand, the laminate preferably has a fixed portion which is configured to be fixed to a transfer device and a finger portion extending from the fixed portion in a substantially U-shape. Examples of such a shape include the shape illustrated in FIG. 2.

### Other Embodiments

The laminate of the present embodiment is not limited to the laminate described above.

For example, the laminate may further have a layer (c) containing a woven fabric of glass fibers and a matrix resin (hereinafter, also referred to as "layer (c)") on at least one of outermost layers thereof. That is, at least one of the outermost layers of the laminate may be the layer (c). When the laminate has the layer (c) on the outermost layer thereof, for example, in a case where the through holes 23 are provided in the laminate 200 as in the example illustrated in FIG. 2, it is easy to suppress occurrence of chipping on the surface of the laminate 200.

Only one outermost layer of the laminate may be the layer (c), or both outermost layers may be the layers (c).

The layer (c) is a cured product of a cloth prepreg in which a woven fabric woven with glass fibers is impregnated with a matrix resin.

As the matrix resin, an epoxy resin (V) is preferred. Examples of the epoxy resin (V) include the epoxy resin (N) exemplified above.

In addition, the shape of the laminate in a case where the laminate of the present embodiment is used as a transfer hand is not limited to the shape illustrated in FIG. 2. For example, the laminate 200 illustrated in FIG. 2 has a substantially U-shaped finger portion with a tip branched into two, but the tip may be branched into three or more. The tip is preferably branched in the same direction.

In addition, the laminate 200 illustrated in FIG. 1 has four first layers (a) 210, but the total number of the first layers (a) is not particularly limited as long as it is two or more. However, in order to establish a symmetric laminate structure, the total number of the first layers (a) is preferably an even number.

In addition, the laminate 200 illustrated in FIG. 1 has one second layer (b) 220 in the middle of the plurality of first layers (a) 210, but the position of the second layer (b) may not be the middle of the plurality of first layers (a), that is, the center (middle) in the thickness direction (lamination direction) of the laminate. As described above, the laminate preferably has a symmetric laminate structure from the viewpoint of suppressing warpage during processing. Therefore, when the second layer (b) is not positioned in the middle of the plurality of first layers (a), two second layers (b) are preferably provided so as to establish a symmetric laminate structure. For example, in a case where the second layer (b) is provided between the first layer a 211 and the second layer a 212 illustrated in FIG. 1, the second layer (b) is preferably provided also between the third layer a 213 and the fourth layer a 214.

However, since the second layer (b) tends to have a lower Young's modulus than the first layer (a), when the number of the second layers (b) increases, the Young's modulus of the laminate as a whole also decreases, and the deflection under load tends to increase. In order to suppress the decrease in the Young's modulus of the laminate as a whole, the number of the first layers (a) may be increased, and the total thickness of the laminate increases accordingly.

From the viewpoint of suppressing the decrease in Young's modulus without increasing the thickness of the laminate, as illustrated in FIG. 1, the second layer (b) 220 is preferably provided as one layer only in a region including the middle of the plurality of first layers (a) 210, that is, the center of the laminate 200 in the thickness direction, particularly, the second layer (b) 220 is preferably provided in a region including the center in the thickness direction and falling within a length of 20% or less of the length of the thickness from the center, more preferably provided in a region falling within a length of 15% or less, and even more preferably provided in a region falling within a length of 10% or less.

### Method for Manufacturing Laminate

A method for manufacturing the laminate according to the embodiment is not particularly limited, and the laminate can be manufactured by, for example, pressurizing a laminate precursor in which first layers (A) are disposed on both surfaces of a second layer (B).

Each of the first layers (A) is a layer selected from a carbon fiber prepreg layer (A1) (hereinafter also referred to as "layer (A1)"), a ceramic layer (A2), and a metallic layer (A3). The second layer (B) is a layer selected from a layer (B1) mainly containing an epoxy resin (S) (hereinafter, also referred to as "layer (B1)") and a layer (B2) mainly containing a thermoplastic elastomer (T) (hereinafter, also referred to as "layer (B2)"). A proportion of a thickness of the second layer (B) is 0.3% or more and less than 30% relative to a total thickness of the first layers (A) and the second layer (B).

The laminate precursor will be described later.

For example, a press machine can be used for pressurizing the laminate precursor.

A pressure during the pressurization is preferably 0.1 MPa or more and 1.0 MPa or less, and more preferably 0.3 MPa or more and 0.8 MPa or less.

When the first layer (a) is the layer (a1), the laminate according to the embodiment is obtained by pressurizing and thermally curing the laminate precursor. For example, it is preferable to manufacture a laminate by heating and pressurizing the laminate precursor at a desired temperature and pressure using a press machine, an autoclave, or the like.

The temperature during the thermal curing is preferably 120°C or higher and 150°C or lower, and more preferably 130°C or higher and 140°C or lower.

In addition, examples of the method for manufacturing a laminate in which the first layer (a) is the layer (a1), that is, the cured product of the layer (A1), and the second layer (b) is the layer (b1) include the following methods (i) to (vi).
(i): A method of laminating the layer (A1) and the layer (B1) in a desired order, and curing and adhering a resin component by heating or the like to integrate the layers.
(ii): A method of laminating the epoxy resin (S) (for example, the stretchable epoxy resin composition described above) used for the layer (B1) on the layer (A1), further laminating the layer (A1) thereon, and curing and adhering a resin component by heating or the like to integrate the layers.
(iii): A method of laminating the epoxy resin (S) (for example, the stretchable epoxy resin composition described above) used for the layer (B1) on the layer (A1), curing and adhering a resin component by heating or the like to integrate the layers, thereby obtaining the layer (a1) and the layer (b1), then further laminating the layer (A1) on the layer (b1), and curing and adhering a resin component by heating or the like to integrate the layers.
(iv): A method of previously curing the layer (A1) to obtain the layer (a1), then laminating the epoxy resin (S) (for example, the stretchable epoxy resin composition described above) used for the layer (B1) on the layer (a1), curing and adhering a resin component by heating or the like to integrate the layers, thereby obtaining the layer (b1), then further laminating the layer (A1) on the layer (b1), and curing and adhering a resin component by heating or the like to integrate the layers.
(v): A method of previously curing the layer (A1) to obtain the layer (a1), then laminating the epoxy resin (S) (for example, the stretchable epoxy resin composition described above) used for the layer (B1) on the layer (a1), and further laminating the layer (A1) or the layer (a1) thereon, followed by curing and adhering by heating or the like to integrate the layers.
(vi): A method of laminating an adhesive between the layer (a1) and the layer (B1), and laminating and integrating the layers in a desired order.

The resin component in this paragraph refers to the epoxy resin (N) or the epoxy resin (S).

Among these, the method (i) has advantages that a material such as a sheet having an appropriately adjusted degree of curing can be used as the layer (B1), that replacement at the time of lamination on the layer (A1) is easy, that the thickness is easily controlled since the material is not easily melted even in a heated state, and that the material such as a sheet to be used is likely to be excellent in followability to a curved surface or the like in a case where the material has stretchability. In addition, in the case of adhering by heating, there is also an advantage that an adhesive force at an interface between the layer (a1) and the layer (B1) is further increased. Further, since the layer (A1) is in a semi-cured state, when shaping into an actual product by shaping molding such as press molding, it is also possible to bond and integrate the layer (a1) and the layer (B1) simultaneously with the shaping, and there is also an advantage that the process is simplified.

For example, when the first layer (A) is either the ceramic layer (A2) or the metallic layer (A3), and the second layer (B) is the layer (B1) or the layer (B2), a laminate may be manufactured by bonding the plurality of first layers (A) to both surfaces of the second layer (B) via an adhesive to form a laminate precursor, placing a weight on the laminate precursor, and allowing the laminate precursor to stand at an ordinary temperature to bond and integrate the first layers (A) and the second layer (B).

Alternatively, for example, the laminate may be manufactured by laminating a layer (C) described below, the first layer (A), and the second layer (B) in a desired order, and curing and adhering a resin component by heat or the like to integrate the layers. A cured product of the layer (C) is also referred to as "glass cloth resin composite layer".

When the laminate is used for, for example, a transfer hand, the laminate precursor may be processed in advance so as to have a desired shape as illustrated in FIG. 2, or a rectangular laminate precursor may be thermally cured to obtain a laminate, and then the obtained laminate may be punched and processed using a punching die or the like so as to have a desired shape.

In addition, in a case where the laminate is manufactured by the above-described methods (i) to (vi), it is preferable that the obtained laminate should be punched and processed using a punching die or the like so as to have a desired shape.

When the plurality of first layers (a) constituting the laminate are the layers (a1) and the plurality of first layers (a) have the layer (a11), it is preferable to punch out the laminate using a punching die or the like so that the orientation direction of the pitch-based carbon fibers contained in at least one layer (a11) is the extension direction of the finger portion (X direction in FIG. 2).

### Laminate Precursor

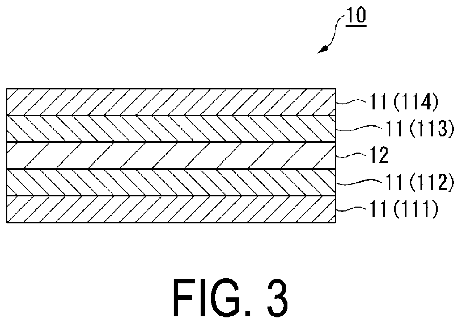

FIG. 3 illustrates an example of a laminate precursor used for manufacturing the laminate according to the embodiment.

A laminate precursor 10 illustrated in FIG. 3 has four first layers (A) 11 and one second layer (B) 12 provided in the middle of these first layers (A) 11.

### First Layer (A)

Each of the first layers (A) is a layer selected from a carbon fiber prepreg layer (A1), a ceramic layer (A2), and a metallic layer (A3).

Among these, the first layer (A) is preferably the layer (A1) from the viewpoint of weight reduction. A cured product of the layer (A1) is a layer (a1).

As the layer (A1), a prepreg containing the carbon fibers (M) and the matrix resin described for the layer (a1) can be used, and a layer of a prepreg containing the carbon fibers (M) and the epoxy resin (N) is preferable.

The layer (A1) may further contain, in addition to the carbon fibers (M) and the matrix resin, a component other than the carbon fibers (M) and the matrix resin (hereinafter, also referred to as "additional component") as necessary as long as the effects of the present invention are not impaired.

The carbon fibers (M) used in the layer (A1) are as described for the layer (a1).

In the present invention, the layer (A1) of the prepreg containing the carbon fibers (M) aligned in one direction is particularly referred to as "unidirectional prepreg layer (A1)". Among them, particularly, a unidirectional prepreg layer (A1) containing the pitch-based carbon fibers aligned in one direction is referred to as "layer (A11)", and a unidirectional prepreg layer (A1) containing the PAN-based carbon fibers aligned in one direction is referred to as "layer (A12)".

A cured product of the layer (A11) is the layer (a11), and a cured product of the layer (A12) is the layer (a12).

The matrix resin used in the layer (A1) is as described for the layer (a1), and is preferably the epoxy resin (N).

The epoxy resin (N) contained in the layer (A11) is the epoxy resin (N1)", and the epoxy resin (N) contained in the layer (A12) is the epoxy resin (N2)". The epoxy resin (N1) and the epoxy resin (N2) may be the same or different.

Examples of the additional component used in the layer (A1) include fibers (additional fibers) other than the carbon fibers (M) described for the layer (a1), and various additives.

For the layer (A1), for example, a prepreg in which the carbon fibers (M) are impregnated with the matrix resin, or a so-called semipreg in which the carbon fibers (M) are partially impregnated (semi-impregnated) with the matrix resin to control an amount of voids can be used.

The prepreg or semipreg containing the carbon fibers (M) and the matrix resin can be manufactured by a known method. For example, a prepreg or semipreg is obtained by coating a resin composition containing a matrix resin to a carbon fiber base material such as a sheet in which the carbon fibers (M) are aligned in one direction, then sandwiching the carbon fiber base material between release paper or the like as necessary, and passing the carbon fiber base material through a pressing roll to impregnate the carbon fiber base material with a resin composition. Alternatively, a prepreg or semipreg may be manufactured by supplying a carbon fiber base material to the surface of a film obtained by coating the surface of release paper or the like with a predetermined amount of a resin composition, then passing the carbon fiber base material through a pressing roll to impregnate the carbon fiber base material with the resin composition.

A basis weight of the carbon fiber base material is preferably 75 g/m² or more and 560 g/m² or less, and more preferably 125 g/m² or more and 450 g/m² or less.

The carbon fiber base material may contain additional fibers as necessary.

The resin composition may contain an additional thermosetting resin and an optional component as necessary in addition to the epoxy resin (N).

A content of the carbon fibers (hereinafter referred to as "fiber content") per layer (A1) is preferably 45 vol% or more, more preferably 50 vol% or more, and even more preferably 55 vol% or more, and is preferably 75 vol% or less, more preferably 70 vol% or less, and even more preferably 65 vol% or less, relative to a total volume per layer (A1). When the fiber content is not less than the lower limit value described above, the mechanical properties of the laminate are further enhanced. When the fiber content is not greater than the upper limit value described above, adhesion between the carbon fibers (M) and the epoxy resin (N) can be sufficiently ensured. The upper limits and the lower limits of the fiber content per layer (A1) can be arbitrarily combined, and the fiber content can be, for example, from 45 to 75 vol%, from 50 to 70 vol%, or from 55 to 65 vol%.

A content of the epoxy resin (N) (hereinafter, also referred to as "resin content") per layer (A1) is preferably 20 mass% or more, more preferably 25 mass% or more, and even more preferably 30 mass% or more, and is preferably 45 mass% or less, more preferably 40 mass% or less, and even more preferably 35 mass% or less, relative to a total mass per layer (A1). When the resin content is not less than the lower limit value described above, the adhesion between the carbon fibers (M) and the epoxy resin (N) can be sufficiently ensured. When the resin content is not greater than the upper limit value described above, the mechanical properties of the laminate are further enhanced. The upper limits and the lower limits of the resin content per layer (A1) can be arbitrarily combined, and the resin content can be, for example, from 20 to 45 mass%, from 25 to 40 mass%, or from 30 to 35 mass%.

A thickness per layer (A1) is preferably 0.1 mm or more, more preferably 0.15 mm or more, and even more preferably 0.2 mm or more, and is preferably 1.5 mm or less, more preferably 1.0 mm or less, and even more preferably 0.8 mm or less. When the thickness per layer (A1) is not less than the lower limit value described above, a desired thickness can be obtained with a relatively small number of layers. When the thickness per layer (A1) is not greater than the upper limit value described above, the desired thickness can be obtained with a smaller number of layers. The upper limits and the lower limits of the thickness per layer (A1) can be arbitrarily combined, and the thickness can be, for example, from 0.1 to 1.5 mm, from 0.15 to 1.0 mm, or from 0.2 to 0.8 mm.

The thickness (average thickness) of the layer (A1) is measured by observing a cross section of the laminate precursor with a microscope or the like, and is determined by an arithmetic mean thereof.

As the prepreg used for the layer (A1), a commercially available product can also be used, and examples thereof include prepregs having trade names "HyEJ43M80QD", "HyEJ28M80QD", "HyEJ12-23", "TR350C 175S", "HyEJ12M80QD", and "HyEJ25M80PD" available from Mitsubishi Chemical Corporation.

### Layer Configuration

In a case where the plurality of first layers (A) are the layers (A1), the plurality of first layers (A) preferably have at least the layer (A11).

All of the plurality of first layers (A) may be constituted by the layer (A11), or may have the layer (A11) and a layer other than the layer (A11), for example, may have the layer (A11) and the layer (A12).

In addition, the plurality of first layers (A) preferably have a unidirectional prepreg (hereinafter, also referred to as "layer (α₀)") containing carbon fibers oriented at an orientation angle of 0° when a longitudinal direction of the laminate precursor is 0°, that is, oriented so as to be parallel to the longitudinal direction of the laminate precursor. A cured product of the layer (α₀) is the layer (β₀).

The layer (α₀) preferably includes at least one of the layer (A11) and the layer (A12), more preferably includes at least the layer (A11), and even more preferably is the layer (A11). When the layer (α₀) includes the layer (A11), the vibration damping properties of the laminate are further improved.

Hereinafter, the layer (A11) in which the orientation angle of the pitch-based carbon fibers is 0° is particularly referred to as "layer (A11₀)", and the layer (A12) in which the orientation angle of the PAN-based carbon fibers is 0° is particularly referred to as "layer (A12₀)".

One type of the layer (α₀) may be used, or two or more types thereof may be used.

The plurality of first layers (A) preferably have a layer (α₀) and a layer (α) containing carbon fibers oriented at an orientation angle of 45° or more and 90° or less relative to orientation of the carbon fibers contained in the layer (α₀). That is, the plurality of first layers (A) preferably have two or more layers having different orientation angles of the carbon fibers, specifically, the layer (α₀) and the layer (α), and more preferably have the layer (A11₀) and the layer (α).

Since the plurality of first layers (A) have the layer (α₀) and the layer (α), it is possible to prevent a crack in the laminate while improving the vibration damping properties of the laminate.

In a case where the plurality of first layers (A) have the layer (α₀) and the layer (α), the layer (α₀) is preferably positioned closer to an outermost layer side of the laminate precursor than the layer (α).

The layer (α) preferably includes at least one of the layer (A11) and the layer (A12).

In particular, from the viewpoint of suppressing the deflection in a direction of 45° or more and 90° or less relative to the orientation of the carbon fibers contained in the layer (α₀), the layer (α) is preferably the layer (A11). When the layer (α₀) and the layer (α) are the layers (A11), the epoxy resin (N1) contained in the layer (A11₀) that is the layer (α₀) and the epoxy resin (N1) contained in the layer (A11) that is the layer (α) may be the same type or different types.

From the viewpoint of increasing strength of the laminate and reducing the manufacturing cost, the layer (α) is preferably the layer (A12).

One type of the layer (α) may be used, or two or more types thereof may be used.

An orientation angle (θ) of the carbon fibers contained in the layer (α) is 45° or more and 90° or less, preferably 45°, 60° or 90°, more preferably 45° or 90°, and particularly preferably 90°, when the orientation angle (θ₀) of the carbon fibers contained in the layer (α₀) is defined as 0°.

In the present description, the layer (A1) containing the carbon fibers having an orientation angle (θ) of 90° and the epoxy resin (N) is referred to as "layer (α₉₀)". In particular, the case where the pitch-based carbon fibers are included as the carbon fibers is also referred to as "layer (A11₉₀)", and the case where the PAN-based carbon fibers are included as the carbon fibers is also referred to as "layer (A12₉₀)". The other orientation angles (θ) are also expressed in the same manner.

Examples of the configuration of the plurality of first layers (A) include combinations as indicated below.
· Combination of layer (A11₀) and layer (A11₉₀).
· Combination of layer (A11₀) and layer (A12₉₀).
· Combination of layer (A11₀), layer (A11₉₀), and layer (A12₉₀).
· Combination of layer (A11₀) and layer (A11₄₅).
· Combination of layer (A11₀) and layer (A12₄₅).
· Combination of layer (A11₀), layer (A11₄₅), and layer (A12₄₅).
· Combination of layer (A11₀) and layer (A11₆₀).
· Combination of layer (A11₀) and layer (A12₆₀).
· Combination of layer (A11₀), layer (A11₆₀), and layer (A12₆₀).
· Combination of layer (A11₀), layer (A11₉₀), and layer (A11₄₅).
· Combination of layer (A11₀), layer (A12₉₀), and layer (A12₄₅).
· Combination of layer (A11₀), layer (A11₉₀), and layer (A12₄₅).
· Combination of layer (A11₀), layer (A12₉₀), and layer (A11₄₅).
· Combination of layer (A12₀) and layer (A12₉₀).

The laminate precursor preferably has a symmetric laminate structure from the viewpoint of suppressing warpage during processing. Therefore, for example, in the case of the laminate precursor 10 illustrated in FIG. 3, when the four first layers (A) 11 are referred to as first A layer 111, second A layer 112, third A layer 113, and fourth A layer 114 in order from the bottom, the first A layer 111 and the fourth A layer 114 are preferably the same layers (A1), and the second A layer 112 and the third A layer 113 are preferably the same layers (A1). In a case where the plurality of first layers (A) 11 have the layer (α₀), at least the first A layer 111 and the fourth A layer 114 are preferably the layers (α₀), and more preferably the layers (A11₀).

Here, the term "the same" means that the layers (A1) have the same configuration, and also have the same thickness and the same orientation angle of the carbon fibers.

When the first layer (A) is either the ceramic layer (A2) or the metallic layer (A3), examples of the configuration of the plurality of first layers (A) include combinations as indicated below.
· Combination of ceramic layer (A2) and ceramic layer (A2).
· Combination of aluminum layer and aluminum layer.
· Combination of SUS layer and SUS layer.
· Combination of titanium alloy layer and titanium alloy layer.

Thicknesses per ceramic layer (A2) and per metallic layer (A3) are each preferably 0.4 mm or more, and more preferably 0.6 mm or more, and are preferably 1.5 mm or less, and more preferably 1.0 mm or less. When the thickness per layer is not less than the lower limit value described above, a desired thickness can be obtained with a relatively small number of layers. When the thickness per layer is not greater than the upper limit value described above, the desired thickness can be obtained with a smaller number of layers. The upper limits and the lower limits of the thickness per ceramic layer (A2) or metallic layer (A3) can be arbitrarily combined, and the thickness can be, for example, from 0.4 to 1.5 mm or from 0.6 to 1.0 mm.

The thickness (average thickness) of each of the ceramic layer (A2) and the metallic layer (A3) is measured by observing the cross section of the laminate precursor with a microscope or the like, and is determined by an arithmetic mean thereof.

### Second Layer (B)

The second layer (B) 12 illustrated in FIG. 3 is positioned in the middle of the four first layers (A). The "middle" referred to herein is a center (middle) of the laminate precursor 10 in a thickness direction (lamination direction), and, in the example illustrated in FIG. 3, is between the second A layer 112 and the third A layer 113. That is, the second layer (B) 12 in the example illustrated in FIG. 3 is an intermediate layer of the laminate precursor 10, and is disposed only in a region including the center of the laminate precursor 10 in the thickness direction.

The second layer (B) is a layer selected from a layer (B1) mainly containing an epoxy resin (S) (provided that the carbon fiber prepreg layer (a1) is excluded) and a layer (B2) mainly containing a thermoplastic elastomer (T).

The layer (B1) of the laminate precursor after pressurization is the layer (b1) in the laminate. The layer (B2) of the laminate precursor after pressurization is the layer (b2) in the laminate.

From the viewpoint of the vibration damping effect, the second layer (B) is preferably the layer (B1).

### Layer (B1)

The layer (B1) is a layer (epoxy resin layer) mainly containing an epoxy resin (S). However, the phrase "mainly containing an epoxy resin (S)" means that a proportion of the epoxy resin (S) to a total mass of the layer (B1) is 50 mass% or more.

The proportion of the epoxy resin (S) to the total mass of the layer (B1) is preferably 70 mass% or more, and more preferably 90 mass% or more.

The layer (B1) may further contain a component other than the epoxy resin (S) as necessary in addition to the epoxy resin (S) as long as the effects of the present invention are not impaired. The epoxy resin (S) and an additional component other than the epoxy resin (S) are as described for the layer (b1).

The layer (B1) is preferably a sheet or film of the epoxy resin (S).

An elongation at break of the layer (B1) is preferably 100% or more, and more preferably 200% or more, and is preferably 500% or less, and more preferably 400% or less. When the elongation at break of the layer (B1) is not less than the lower limit value described above, the vibration damping properties of the laminate are further improved. When the elongation at break of the layer (B1) is not greater than the upper limit value described above, the rigidity of the laminate is further improved. The upper limits and the lower limits of the elongation at break of the layer (B1) can be arbitrarily combined, and the elongation at break can be set to, for example, from 100 to 500% or from 200 to 400%.

The elongation at break of the layer (B1) can be determined as follows. That is, the layers other than the layer (B1) are shaved off from the laminate precursor; the laminate is cut into a 10 mm wide × 50 mm long test piece; a tensile test is performed at a test speed of 200 mm/min in an environment of 23°C and 50% RH in accordance with JIS K 7127:1999; and the elongation at tensile break is measured.

A tensile modulus of the layer (B1) is preferably 3 MPa or more, more preferably 3.5 MPa or more, and even more preferably 4 MPa or more, and is preferably 12 MPa or less, more preferably 10 MPa or less, and even more preferably 8 MPa or less. When the tensile modulus of the layer (B1) is not less than the lower limit value described above, the rigidity of the laminate is further improved. When the tensile modulus of the layer (B1) is not greater than the upper limit value described above, the vibration damping properties of the laminate are further improved. The upper limits and the lower limits of the tensile modulus of the layer (B1) can be arbitrarily combined, and the tensile modulus can be, for example, from 3 to 12 MPa, from 3.5 to 10 MPa, or from 4 to 8 MPa.

The tensile modulus of the layer (B1) can be determined as follows. That is, the layers other than the layer (B1) are shaved off from the laminate precursor; the laminate is cut into a 10 mm wide × 50 mm long test piece; and the tensile modulus of the test piece is measured by the dynamic viscoelasticity measurement method described in JIS K 7244-4:1999 using a dynamic viscoelasticity measuring device (for example, product name "DVA-200" available from IT Keisoku Seigyo K. K.) under measuring conditions of a frequency of 1 Hz, a temperature rising rate of 3°C/min, and a double-supported tensile mode.

A tensile strength of the layer (B1) is preferably 10 MPa or more, more preferably 15 MPa or more, and even more preferably 20 MPa or more, and is preferably 50 MPa or less, more preferably 45 MPa or less, and even more preferably 40 MPa or less. When the tensile strength of the layer (B1) is not less than the lower limit value described above, the rigidity of the laminate is further improved. When the tensile strength of the layer (B1) is not greater than the upper limit value described above, the vibration damping properties of the laminate are further improved. The upper limits and the lower limits of the tensile strength of the layer (B1) can be arbitrarily combined, and the tensile strength can be, for example, from 10 to 50 MPa, from 15 to 45 MPa, or from 20 to 40 MPa.

The tensile strength of the layer (B1) can be determined as follows. That is, the layers other than the layer (B1) are shaved off from the laminate precursor; the laminate is cut into a 10 mm wide × 50 mm long test piece; and the tensile strength of the test piece is measured by the dynamic viscoelasticity measurement method described in JIS K 7244-4:1999 using a dynamic viscoelasticity measuring device (for example, product name "DVA-200" available from IT Keisoku Seigyo K. K.) under measuring conditions of a frequency of 1 Hz, a temperature rising rate of 3°C/min, and a double-supported tensile mode.

The layer (B1) is obtained, for example, by molding the epoxy resin (S) and, if necessary, an additional component into a sheet or film shape. An example of a preferred aspect of a method for manufacturing the layer (B1) is a method of curing the stretchable epoxy resin composition containing the main agent, the curing agent, and the like described above into a sheet or film shape.

The term "curing" as used herein means pre-curing of the stretchable epoxy resin composition by heat, light, electron beam, or the like. A degree of curing is not particularly limited, and the layer (B1) may be a completely or almost completely cured product or a semi-cured product, and the degree of curing may be appropriately adjusted according to the purpose, application, and the like.

The layer (B1) can be manufactured by, for example, curing the stretchable epoxy resin composition in a state of being molded into a sheet or film (hereinafter, referred to as "sheet or the like") having a predetermined thickness. The layer (B1) can also be manufactured by molding a semi-cured product obtained from the stretchable epoxy resin composition into a sheet shape or the like having a predetermined thickness. Specifically, the layer (B1) is obtained by: a method in which a stretchable epoxy resin composition is applied onto a carrier sheet, the resin composition is cured to form a stretchable epoxy resin sheet or the like, and then the carrier sheet is peeled off to form a stretchable epoxy resin sheet or the like; a method in which a stretchable epoxy resin composition is applied onto a first carrier sheet, a second carrier sheet is bonded to a surface of the resin composition opposite to a surface provided with the first carrier sheet, the resin composition is then cured to form a stretchable epoxy resin sheet or the like, and both carrier sheets are peeled off; or the like.

A method for curing the stretchable epoxy resin composition varies depending on the components to be blended in the stretchable epoxy resin composition, the amounts of the components to be blended, or the shape of the blend (for example, the thickness of the sheet or film), but is usually, for example, a method of heating at 23°C or higher and 200°C or lower for 5 minutes or more and 24 hours or less. The heating is preferably performed by a one step treatment of performing primary heating at 23°C or higher and 160°C or lower for 5 minutes or more and 24 hours or less, a two step treatment of performing secondary heating at 80°C or higher and 200°C or lower, which is higher than the primary heating temperature by 40 to 177°C, for 5 minutes or more and 24 hours or less in addition to the one step treatment, or a three step treatment of performing tertiary heating at 100°C or higher and 200°C or lower, which is higher than the secondary heating temperature, for 5 minutes or more and 24 hours or less in addition to the two step treatment, from the viewpoint of reducing curing failure.

When the layer (B1) is manufactured as a semi-cured product, the curing reaction of the stretchable epoxy resin composition may be allowed to proceed to such an extent that the shape can be maintained by heating or the like. When the stretchable epoxy resin composition contains a solvent, most of the solvent is removed by a method such as heating, pressure reduction, or air drying, but 5 mass% or less of the solvent may remain in the semi-cured product.

### Layer (B2)

The layer (B2) is a layer mainly containing a thermoplastic elastomer (T). However, the phrase "mainly containing a thermoplastic elastomer (T)" means that a proportion of the thermoplastic elastomer (T) to a total mass of the layer (B2) is 50 mass% or more.

The proportion of the thermoplastic elastomer (T) to the total mass of the layer (B2) is preferably 70 mass% or more, and more preferably 90 mass% or more.

In addition to the thermoplastic elastomer (T), the layer (B2) may further contain a component other than the thermoplastic elastomer (T) as necessary as long as the effects of the present invention are not impaired. The thermoplastic elastomer (T) and an additional component other than the thermoplastic elastomer (T) are as described for the layer (b2).

The layer (B2) is preferably a sheet or film of the thermoplastic elastomer (T).

An elongation at break of the layer (B2) is preferably 800% or more, and more preferably 900% or more and 1100% or less, and is preferably 1200% or less, and more preferably 1100% or less. When the elongation at break of the layer (B2) is not less than the lower limit value described above, the vibration damping properties of the laminate are further improved. When the elongation at break of the layer (B2) is not greater than the upper limit value described above, the rigidity of the laminate is further improved. The upper limits and the lower limits of the elongation at break of the layer (B2) can be arbitrarily combined, and the elongation at break can be set to, for example, from 800 to 1200% or from 900 to 1100%.

The elongation at break of the layer (B2) can be determined as follows. That is, the layers other than the layer (B2) are shaved off from the laminate precursor; the laminate is cut into a 10 mm wide × 50 mm long test piece; a tensile test is performed at a test speed of 200 mm/min in an environment of 23°C and 50% RH in accordance with JIS K 7127:1999; and the elongation at tensile break is measured.

A tensile modulus of the layer (B2) is preferably 3 MPa or more, more preferably 3.5 MPa or more, and even more preferably 4 MPa or more, and is preferably 20 MPa or less, more preferably 15 MPa or less, and even more preferably 10 MPa or less. When the tensile modulus of the layer (B2) is not less than the lower limit value described above, the rigidity of the laminate is further improved. When the tensile modulus of the layer (B2) is not greater than the upper limit value described above, the vibration damping properties of the laminate are further improved. The upper limits and the lower limits of the tensile modulus of the layer (B2) can be arbitrarily combined, and the tensile modulus can be, for example, from 3 to 20 MPa, from 3.5 to 15 MPa, or from 4 to 10 MPa.

The tensile modulus of the layer (B2) can be determined as follows. That is, the layers other than the layer (B2) are shaved off from the laminate precursor; the laminate is cut into a 10 mm wide × 50 mm long test piece; and the tensile modulus of the test piece is measured by the dynamic viscoelasticity measurement method described in JIS K 7244-4:1999 using a dynamic viscoelasticity measuring device (for example, product name "DVA-200" available from IT Keisoku Seigyo K. K.) under measuring conditions of a frequency of 1 Hz, a temperature rising rate of 3°C/min, and a double-supported tensile mode.

A tensile strength of the layer (B2) is preferably 8 MPa or more, more preferably 9 MPa or more, and even more preferably 10 MPa or more, and is preferably 40 MPa or less, more preferably 35 MPa or less, and even more preferably 30 MPa or less. When the tensile strength of the layer (B2) is not less than the lower limit value described above, the rigidity of the laminate is further improved. When the tensile strength of the layer (B2) is not greater than the upper limit value described above, the vibration damping properties of the laminate are further improved. The upper limits and the lower limits of the tensile strength of the layer (B2) can be arbitrarily combined, and the tensile strength can be, for example, from 8 to 40 MPa, from 9 to 35 MPa, or from 10 to 30 MPa.

The tensile strength of the layer (B2) can be determined as follows. That is, the layers other than the layer (B2) are shaved off from the laminate precursor; the laminate is cut into a 10 mm wide × 50 mm long test piece; and the tensile strength of the test piece is measured by the dynamic viscoelasticity measurement method described in JIS K 7244-4:1999 using a dynamic viscoelasticity measuring device (for example, product name "DVA-200" available from IT Keisoku Seigyo K. K.) under measuring conditions of a frequency of 1 Hz, a temperature rising rate of 3°C/min, and a double-supported tensile mode.

The layer (B2) is obtained by, for example, molding the thermoplastic elastomer (T) into a sheet or film shape. An example of a preferred aspect of a method for manufacturing the layer (B2) is a method of extrusion-molding the elastomer composition containing the thermoplastic elastomer (T) described above into a sheet or film shape.

### Thickness

A proportion of a thickness of the second layer (B) is 0.3% or more and less than 30% relative to a total thickness of the first layer (A) and the second layer (B). When the proportion of the thickness of the second layer (B) is not less than the lower limit value described above, sufficient vibration damping performance can be expected to be exhibited. When the proportion of the thickness of the second layer (B) is not greater than the upper limit value described above, the influence on the deflection performance under load can be further suppressed. The proportion of the thickness of the second layer (B) is preferably 1% or more, and more preferably 3% or more. The proportion of the thickness of the second layer (B) is preferably 20% or less, and more preferably 10% or less. The upper limits and the lower limits of the proportion of the thickness of the second layer (B) can be arbitrarily combined, and the thickness can be, for example, from 1 to 20% or from 3 to 10%.

The thickness (average thickness) of the first layer (A) and the thickness (average thickness) of the second layer (B) are measured by observing the cross section of the laminate precursor with a microscope or the like, and are determined by arithmetic means thereof.

The thickness of the second layer (B) is preferably 0.03 mm or more, more preferably 0.05 mm or more, and even more preferably 0.1 mm or more, and is preferably 0.5 mm or less, more preferably 0.5 mm or less, and even more preferably 0.4 mm or less. The thickness of the second layer (B) is preferably as small as possible as long as the desired vibration damping effect can be obtained. When the thickness of the second layer (B) is not less than the lower limit value described above, the vibration damping properties of the laminate are improved. When the thickness of the second layer (B) is not greater than the upper limit value described above, the influence on the deflection performance under load can be suppressed. The upper limits and the lower limits of the thickness of the second layer (B) can be arbitrarily combined, and the thickness can be, for example, from 0.03 to 0.5 mm, from 0.05 to 0.5 mm, or from 0.1 to 0.4 mm.

A loss tangent (Tan δ) of the second layer (B) is preferably 0.2 or more, and more preferably 0.3 or more at 20°C in an entire frequency range between 100 Hz and 4000 Hz. When the loss tangent (Tan δ) of the second layer (B) is not less than the lower limit value described above, sufficient vibration damping properties can be imparted.

The loss tangent (Tan δ) of the second layer (B) can be determined as follows. The layers other than the second layer (B) are shaved off from the laminate precursor; the laminate is cut into a 10 mm wide × 50 mm long test piece; a storage modulus and a loss modulus are measured using a viscoelasticity measuring machine (for example, product name "Model MCR301" available from Anton Paar GmbH), whose measurement mode is set to a torsion mode under a nitrogen atmosphere at -20°C, -10°C, 0°C, 10°C, and 20°C, a frequency of from 0.1 to 25.1 Hz, and a strain of 0.1%; and a ratio of loss modulus/storage modulus is determined and defined as the loss tangent (Tan δ).

A total thickness of the laminate precursor is preferably 1.5 mm or more, and more preferably 2 mm or more, and is preferably 20 mm or less, more preferably 5 mm or less, and even more preferably 4 mm or less. When the total thickness of the laminate precursor is not less than the lower limit value described above, the laminate can be used as a transfer member (transfer base material) having deflection performance. When the total thickness of the laminate precursor is not greater than the upper limit value described above, the laminate can be used as a transfer member because the laminate has a desired mass or less. The upper limits and the lower limits of the total thickness of the laminate precursor can be arbitrarily combined, and the total thickness can be, for example, from 1.5 to 20 mm, from 1.5 to 5 mm, or from 2 to 4 mm.

A shape of the laminate precursor is not particularly limited, and examples thereof include a flat plate shape, a hollow prismatic shape, and a hollow cylindrical shape. Among these, the flat plate shape is preferable from the viewpoint of easy punching of the laminate precursor into a desired shape.

When the laminate is used for a transfer member such as a transfer hand, the laminate precursor preferably has the same shape as the laminate having the fixed portion 21 which is configured to be fixed to a transfer device and the finger portion 22 extending from the fixed portion 21 in a substantially U-shape, as illustrated in FIG. 2, for example.

When the plurality of first layers (A) constituting the laminate precursor 10 are the layers (A1) and the plurality of first layers (A) have the layer (A11), an orientation direction of the pitch-based carbon fibers contained in the layer (A11) is preferably an extension direction of the finger portion 22 (X direction in FIG. 2). In particular, it is more preferable that the orientation direction of the pitch-based carbon fibers contained in the layer (A11₀) should be the extension direction of the finger portion 22 (X direction). With such a configuration, the vibration damping properties of the laminate are further improved.

### Method for Manufacturing Laminate Precursor

The laminate precursor is obtained by, for example, disposing a plurality of first layers (A) on both surfaces of the second layer (B).

For example, when the first layer (A) is either the ceramic layer (A2) or the metallic layer (A3), a plurality of first layers (A) may be bonded to both surfaces of the second layer (B) via an adhesive.

When the laminate precursor thus obtained is used for, for example, a transfer hand, the laminate precursor may be punched out using a punching die or the like so as to have a desired shape as illustrated in FIG. 2, for example. When the plurality of first layers (A) constituting the laminate precursor 10 are the layers (A1) and the plurality of first layers (A) have the layer (A11), it is preferable to punch out the laminate precursor 10 using a punching die or the like so that the orientation direction of the pitch-based carbon fibers contained in at least one layer (A11) is the extension direction of the finger portion 22 (X direction in FIG. 2).

In the laminate precursor described above, the first layers (A) are disposed on both surfaces of the second layer (B), and the proportion of the thickness of the second layer (B) is controlled to fall within a specific range, and thus a laminate having excellent vibration damping properties is obtained by pressurization.

Since the laminate precursor of the present embodiment can provide a laminate having excellent vibration damping properties, the laminate precursor of the present embodiment is suitable as a precursor of a transfer member (transfer base material) such as a transfer hand or a transfer arm. In particular, when the laminate precursor has a flat plate shape, the laminate precursor is suitable as a precursor of a transfer hand. When the laminate precursor has a hollow prismatic shape or a hollow cylindrical shape, it is suitable as a precursor of a transfer arm.

### Other Embodiments

The laminate precursor is not limited to the above-described laminate precursor.

For example, the laminate precursor may further have a layer (C) of a cloth prepreg containing glass fibers (hereinafter, also referred to as "layer (C)") on at least one of outermost layers thereof. That is, at least one of the outermost layers of the laminate precursor may be the layer (C). When the laminate precursor has the layer (C) on the outermost layer thereof, for example, in a case where the through holes 23 are provided in the laminate 200 as illustrated in FIG. 2, it is possible to suppress occurrence of chipping on the surface of the laminate precursor.

Only one outermost layer of the laminate precursor may be the layer (C), or both outermost layers may be the layers (C).

The layer (C) is a cloth prepreg in which a woven fabric woven with glass fibers is impregnated with a matrix resin.

As the matrix resin, an epoxy resin (V) is preferred. Examples of the epoxy resin (V) include the epoxy resin (N) exemplified above.

The laminate precursor having the layer (C) is obtained by, for example, disposing a plurality of first layers (A) on both surfaces of the second layer (B), and further disposing the layer (C) on at least one of the outermost layers.

In addition, the shape of the laminate precursor in the case of using the laminate precursor as a transfer hand is not limited to the shape for manufacturing the laminate illustrated in FIG. 2, and may be appropriately set according to the shape of the intended laminate.

In addition, the laminate precursor 10 illustrated in FIG. 3 has four first layers (A) 11, but the total number of the first layers (A) is not particularly limited as long as it is two or more. However, in order to establish a symmetric laminate structure, the total number of the first layers (A) is preferably an even number.

In addition, the laminate precursor 10 illustrated in FIG. 3 has one second layer (B) 12 in the middle of the plurality of first layers (A) 11, but the position of the second layer (B) may not be the middle of the plurality of first layers (A), that is, the center (middle) of the laminate precursor in the thickness direction (lamination direction) as long as the second layer (B) is positioned between the plurality of first layers (A). As described above, the laminate precursor preferably has a symmetric laminate structure from the viewpoint of suppressing warpage during processing. Therefore, when the second layer (B) is not positioned in the middle of the plurality of first layers (A), two second layers (B) are preferably provided so as to establish a symmetric laminate structure. For example, in a case where the second layer (B) is provided between the first layer A 111 and the second layer A 112 illustrated in FIG. 3, the second layer (B) is preferably provided also between the third layer A 113 and the fourth layer A 114.

However, since the second layer (B) tends to have a lower Young's modulus than the first layer (A), when the number of the second layers (B) increases, the Young's modulus of the laminate precursor as a whole also decreases, and the deflection under load tends to increase. In order to suppress the decrease in the Young's modulus of the laminate precursor as a whole, the number of the first layers (A) may be increased, and the total thickness of the laminate increases accordingly.

From the viewpoint of suppressing the decrease in Young's modulus without increasing the thickness of the laminate precursor, as illustrated in FIG. 3, the second layer (B) 12 is preferably provided as one layer only in a region including the middle of the plurality of first layers (A) 11, that is, the center of the laminate precursor 10 in the thickness direction, particularly, the second layer (B) 12 is preferably provided in a region including the center in the thickness direction and falling within a length of 20% or less of the length of the thickness from the center, more preferably provided in a region falling within a length of 15% or less, and even more preferably provided in a region falling within a length of 10% or less.

### Transfer Hand

A transfer hand according to an embodiment includes the laminate according to the embodiment described above. The transfer hand according to the embodiment includes the laminate according to the embodiment described above, and thus has excellent vibration damping properties.

The transfer hand may be constituted only by the laminate according to the embodiment, or may include a member other than the laminate according to the embodiment.

An example of a shape of the transfer hand is a shape having a fixed portion which is configured to be fixed to a transfer device and a finger portion extending from the fixed portion in a substantially U-shape, specifically, a shape illustrated in FIG. 2.

When the transfer hand has the shape illustrated in FIG. 2 and the plurality of first layers (a) included in the laminate constituting the transfer hand have the layer (a11), the orientation direction of the pitch-based carbon fibers included in the layer (a11) is preferably the extension direction of the finger portion 22 (X direction in FIG. 2). In particular, it is more preferable that the orientation direction of the pitch-based carbon fibers contained in the layer (a11₀) should be the extension direction of the finger portion 22 (X direction). With such a configuration, the vibration damping properties are further improved.

The shape of the transfer hand is not limited to that illustrated in FIG. 2, and may have, for example, a finger portion having a shape in which the tip is branched into three or more.

### Transfer Device and Semiconductor Manufacturing Device

A transfer device according to an embodiment is a transfer device incorporating the transfer hand according to the embodiment. The transfer device according to the embodiment can employ a known configuration except that the transfer hand according to the embodiment is incorporated.

The semiconductor manufacturing device according to the embodiment is a semiconductor manufacturing device incorporating the transfer hand according to the embodiment. The semiconductor manufacturing device according to the embodiment can employ a known configuration except that the transfer hand according to the embodiment is incorporated.

### Examples

The present invention will be described more specifically with reference to Examples below, but is not limited to the Examples below as long as the gist of the present invention is not exceeded, and various modifications can be made without departing from the gist of the present invention.

### Materials Used

### Prepreg, Sheet

· A1-1: A pitch-based unidirectional prepreg containing pitch-based carbon fibers and an epoxy resin (liquid bisphenol A epoxy resin) (trade name "DIALEAD (trademark)" available from Mitsubishi Chemical Corporation, tensile modulus of pitch-based carbon fibers: 760 GPa).
· A1-2: A PAN-based unidirectional prepreg containing PAN-based carbon fibers and an epoxy resin (liquid bisphenol A epoxy resin) (trade name "PYROFIL (trademark)" available from Mitsubishi Chemical Corporation, tensile modulus of PAN-based carbon fibers: 235 GPa).
· A2-1: A ceramic plate containing 99.9 mass% or more of aluminum oxide (available from Nishimura Advanced Ceramics, Young's modulus: 390 GPa, thickness: 0.74 mm).
· A2-2: A ceramic plate containing more than 96 mass% of aluminum oxide (available from Nishimura Advanced Ceramics, Young's modulus: 329 GPa, thickness: 0.74 mm).
· A2-3: A ceramic plate containing 99.9 mass% or more of aluminum oxide (available from Nishimura Advanced Ceramics, Young's modulus: 390 GPa, thickness: 1.50 mm).
· A2-4: A ceramic plate containing more than 96 mass% of aluminum oxide (available from Nishimura Advanced Ceramics, Young's Modulus: 329 GPa, thickness: 1.50 mm).
· A3-1: An Al-Mg alloy plate (product number: A5052 available from Kobe Steel, Ltd., thickness: 0.74 mm).
· A3-2: An Al-Mg alloy plate (product number: A5052 available from Kobe Steel, Ltd., thickness: 1.50 mm).
· A4-1: A stainless steel plate (SUS304 available from Nippon Steel Corporation, thickness: 1.50 mm).
· B1-1: An epoxy resin sheet prepared as follows (thickness: 0.10 mm).
· B1-2: An epoxy resin sheet prepared as follows (thickness: 0.20 mm).
· B2-1: A thermoplastic elastomer sheet prepared as follows (thickness: 0.20 mm).

### Preparation of B1-1

### Manufacture of Epoxy Resin (S1)

A 1-L glass flask equipped with a stirrer, a dropping funnel, and a thermometer was charged with 141.8 parts by mass of 1,6-hexanediol and 0.51 parts by mass of boron trifluoride ethyl ether, which were preheated to 45°C, and heated to 80°C. Epichlorohydrin (244.3 parts by mass) was added dropwise over a period of time so that the temperature did not reach 85°C or higher. The mixture was aged for 1 hour while maintaining the temperature at 80°C or higher and 85°C or lower, and then cooled to 45°C. To the mixture, 528.0 parts by mass of a 22 mass% aqueous sodium hydroxide solution was added, and the resultant mixture was vigorously stirred at 45°C for 4 hours. The reaction mixture was cooled to room temperature, the aqueous phase was separated and removed, and the unreacted epichlorohydrin and water were removed by heating under reduced pressure to obtain 283.6 parts by mass of crude 1,6-hexanediol diglycidyl ether.

The crude 1,6-hexanediol diglycidyl ether was purified by distillation in an Oldershaw distillation column (15 stages), and a fraction at a pressure of 1300 Pa and 170°C or higher and 190°C or lower was used as a main fraction, thereby obtaining 127.6 parts by mass of 1,6-hexanediol diglycidyl ether having a diglycidyl substance purity of 97 mass% as measured by gas chromatography, a total chlorine amount of 0.15 mass%, and an epoxy equivalent of 116 g/eq.

In a pressure-resistant reaction vessel, 100 parts by mass of the 1,6-hexanediol diglycidyl ether, 69.3 parts by mass of bisphenol F (phenolic hydroxyl group equivalent: 100 g/eq), and 0.13 parts by mass of ethyltriphenylphosphonium iodide (30 mass% methyl cellosolve solution) were placed, and subjected to a polymerization reaction at from 165 to 170°C for 5 hours under a nitrogen atmosphere, to obtain an epoxy resin (S1) which is a copolymer of bisphenol F and 1,6-hexanediol glycidyl ether having an epoxy equivalent of 1000 g/eq and a number average molecular weight of 3000.

### Preparation of Epoxy Resin Sheet

In 100 parts by mass of the epoxy resin (S1), 8.5 parts by mass of a curing agent (trade name "jER (trademark) Cure ST-14" available from Mitsubishi Chemical Corporation) was blended to prepare a stretchable epoxy resin composition. The composition was sandwiched between separator films (trade name "Diafoil (trademark) MRF-75" available from Mitsubishi Chemical Corporation, a polyethylene terephthalate film having one surface coated with silicone, thickness: 75 µm), adjusted to a desired thickness, subjected to a primary heating treatment at 40°C for 16 hours, and further subjected to a secondary heating treatment at 80°C for 6 hours, to obtain an epoxy resin sheet having a thickness of 0.1 mm.

The elongation at break of the obtained epoxy resin sheet was 324%, the tensile modulus of the epoxy resin sheet was 4 MPa, and the tensile strength of the epoxy resin sheet was 37 MPa.

The loss tangent (Tan δ) of the obtained epoxy resin sheet was 0.5 or more at 20°C in the entire frequency range between 100 Hz and 4000 Hz.

### Preparation of B1-2

An epoxy resin sheet having a thickness was obtained in the same manner as B1-1 except that the thickness after the secondary heating treatment was changed to 0.2 mm.

The elongation at break of the obtained epoxy resin sheet was 320%, the tensile modulus of the epoxy resin sheet was 4 MPa, and the tensile strength of the epoxy resin sheet was 37 MPa.

The loss tangent (Tan δ) of the obtained epoxy resin sheet was 0.5 or more at 20°C in the entire frequency range between 100 Hz and 4000 Hz.

### Preparation of B2-1

### Preparation of Thermoplastic Elastomer Sheet

A commercially available thermoplastic elastomer (trade name "Tefabloc" available from Mitsubishi Chemical Corporation, thickness: 0.2 mm) was used.

The elongation at break of the obtained thermoplastic elastomer sheet was 1030%, the tensile modulus of the thermoplastic elastomer sheet was 10 MPa, and the tensile strength of the thermoplastic elastomer sheet was 12 MPa.

### Measurement and Evaluation

### Evaluation of Vibration Damping Properties

The laminate was cut into a 15 mm wide and 222 mm long piece to prepare a test piece.

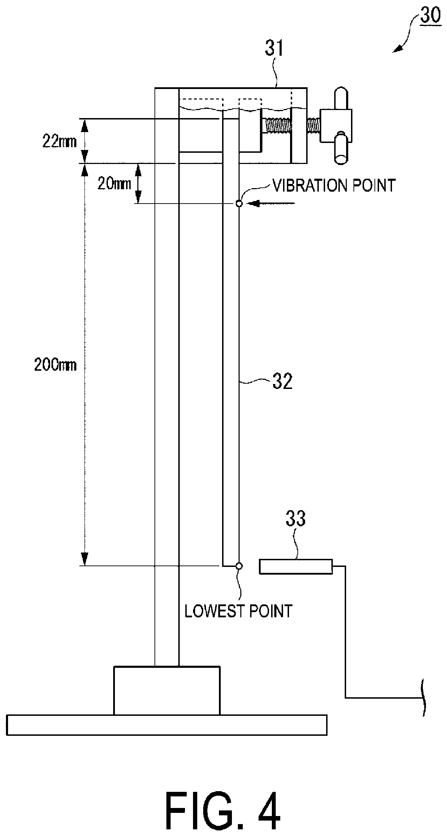

The vibration damping properties of the obtained test piece were evaluated as follows by the one end fixed impact vibration method in accordance with JIS G 0602:1993 using a vibration damping measuring device 30 illustrated in FIG. 4.

A test piece 31 was fixed in a cantilever manner to a fixing jig 32 illustrated in FIG. 4 so that an effective length of the test piece 31 was 200 mm and a gripping margin was 22 mm, and a portion about 20 mm below the fixed end was impacted and vibrated. A time waveform of vibration displacement of the lowest point of the test piece 31 was measured under the condition of an analytical frequency range of 400 Hz using a laser displacement meter (product name "CCD laser displacement meter LK-030" available from Keyence Corporation) 33.

The time required for the amplitude to change from 1 mm to 0.25 mm was measured, and this time was defined as the time (sec) until vibration damping reached 1/4.

Further, the loss factor (23°C) was determined from the damped free vibration waveform by the one end fixed impact vibration method in accordance with JIS G 0602:1993.

### Evaluation of Deflection Amount

The laminate having a width of 16 mm and a length of 250 mm is horizontally fixed to a fixing table, and thus held in a cantilever state (fixed portion: 50 mm, cantilever portion: 200 mm). A 100-gf weight was placed at a position of 10 mm from the tip of the cantilever portion, and a length (deflection amount: mm) by which the tip was lowered was measured.

### Example 1

The PAN-based unidirectional prepreg (A1-2: 90°) and the pitch-based unidirectional prepreg (A1-1: 0°) were laminated in this order on each of both surfaces of the epoxy resin sheet (B1-1) to obtain a laminate precursor (total thickness: 1.56 mm, thickness of A1-1: 0.61 mm, thickness of A1-2: 0.12 mm, thickness of B1-1: 0.10 mm) having a five-layer structure in which A1-1 (0°)/A1-2 (90°)/B1-1/A1-2 (90°)/A1-1 (0°) were laminated in this order. In the present description, the numerical values in parentheses after "A1-1" and "A1-2" are the orientation angles of the carbon fibers.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 1.56 mm.

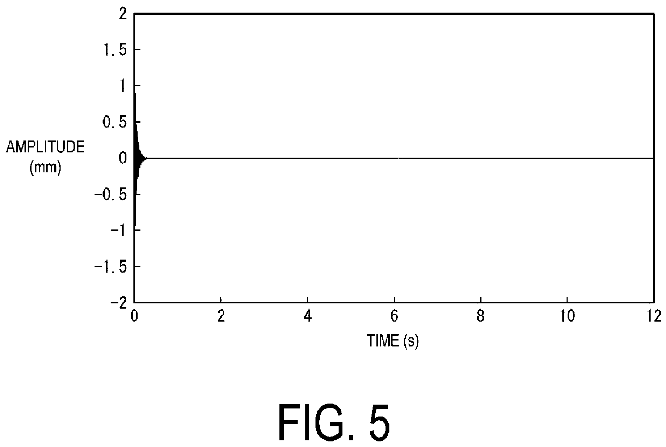

For the obtained laminate, the time (sec) until the vibration damping reached 1/4 was measured, the loss factor was determined, and the deflection amount was further measured. The results are shown in Table 1. Further, the time waveform of the vibration displacement is illustrated in FIG. 5.

### Example 2

The PAN-based unidirectional prepreg (A1-2: 90°) and the PAN-based unidirectional prepreg (A1-2: 0°) were laminated in this order on each of both surfaces of the epoxy resin sheet (B1-1) to obtain a laminate precursor (total thickness: 1.52 mm, thickness of A1-2 (90°): 0.12 mm, thickness of A1-2 (0°): 0.59 mm, thickness of B1-1: 0.1 mm) in which A1-2 (0°)/A1-2 (90°)/B1-1/A1-2 (90°)/A1-2 (0°) were laminated in this order.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 1.52 mm.

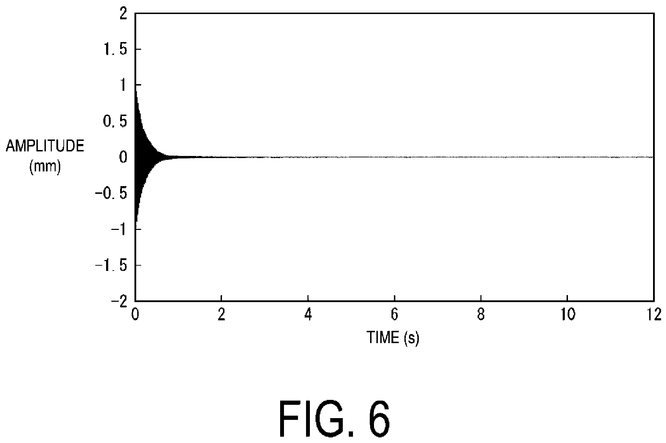

For the obtained laminate, the time (sec) until the vibration damping reached 1/4 was measured, the loss factor was determined, and the deflection amount was further measured. The results are shown in Table 1. Further, the time waveform of the vibration displacement is illustrated in FIG. 6.

### Example 3

The pitch-based unidirectional prepreg (A1-1: 0°) was laminated on each of both surfaces of the epoxy resin sheet (B1-2) to obtain a laminate precursor (total thickness: 2.12 mm, thickness of A1-1: 0.96 mm, thickness of B1-2: 0.2 mm) in which A1-1 (0°)/B1-2/A1-1 (0°) were laminated in this order.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 2.12 mm.

For the obtained laminate, the loss factor was determined. The results are shown in Table 1.

### Example 4

The pitch-based unidirectional prepreg (A1-1: 0°) was laminated on each of both surfaces of the thermoplastic elastomer sheet (B2-1) to obtain a laminate precursor (total thickness: 2.12 mm, thickness of A1-1: 0.96 mm, thickness of B2-1: 0.2 mm) in which A1-1 (0°)/B2-1/A1-1 (0°) were laminated in this order.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 2.12 mm.

For the obtained laminate, the loss factor was determined, and the deflection amount was measured. The results are shown in Table 1.

### Example 5

The ceramic plate (A2-1) was adhered to each of both surfaces of the epoxy resin sheet (B1-1) with an adhesive (trade name "XNR 3305" available from Nagase ChemteX Corporation) to obtain a laminate precursor (total thickness: 1.62 mm) in which A2-1/adhesive/B1-1/adhesive/A2-1 were laminated in this order.

The obtained laminate precursor was placed flat on a surface plate, a 3.74-kg weight was placed on the laminate precursor, and the laminate precursor was allowed to stand overnight at an ordinary temperature to obtain a laminate having a width of 15 mm, a length of 222 mm, and a total thickness of 1.62 mm.

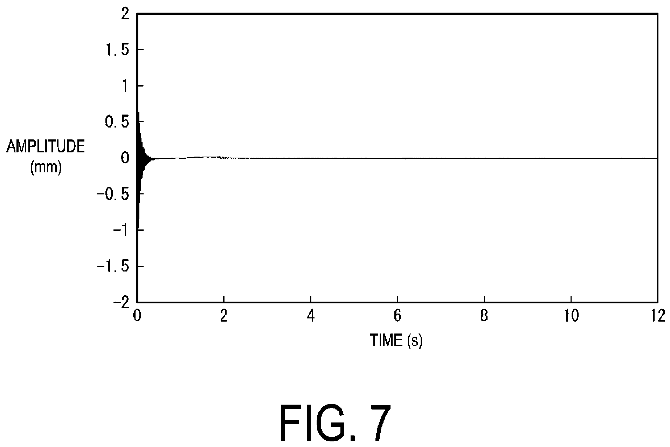

For the obtained laminate, the time (sec) until the vibration damping reached 1/4 was measured, and the loss factor was determined. The results are shown in Table 1. Further, the time waveform of the vibration displacement is illustrated in FIG. 7.

### Example 6

The ceramic plate (A2-2) was adhered to each of both surfaces of the epoxy resin sheet (B1-1) with an adhesive (trade name "XNR 3305" available from Nagase ChemteX Corporation) to obtain a laminate precursor (total thickness: 1.62 mm) in which A2-2/adhesive/B1-1/adhesive/A2-2 were laminated in this order.

The obtained laminate precursor was placed flat on a surface plate, a 3.74-kg weight was placed on the laminate precursor, and the laminate precursor was allowed to stand overnight at an ordinary temperature to obtain a laminate having a width of 15 mm, a length of 222 mm, and a total thickness of 1.62 mm.

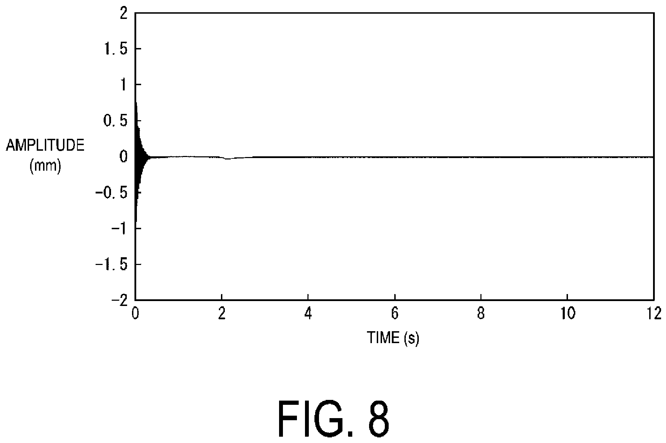

For the obtained laminate, the time (sec) until the vibration damping reached 1/4 was measured, and the loss factor was determined. The results are shown in Table 1. Further, the time waveform of the vibration displacement is illustrated in FIG. 8.

### Example 7

The Al-Mg alloy plate (A3-1) was adhered to each of both surfaces of the epoxy resin sheet (B1-1) with an adhesive (trade name "XNR 3305" available from Nagase ChemteX Corporation) to obtain a laminate precursor (total thickness: 1.62 mm) in which A3-1/adhesive/B1-1/adhesive/A3-1 were laminated in this order.

The obtained laminate precursor was placed flat on a surface plate, a 3.74-kg weight was placed on the laminate precursor, and the laminate precursor was allowed to stand overnight at an ordinary temperature to obtain a laminate having a width of 15 mm, a length of 222 mm, and a total thickness of 1.62 mm.

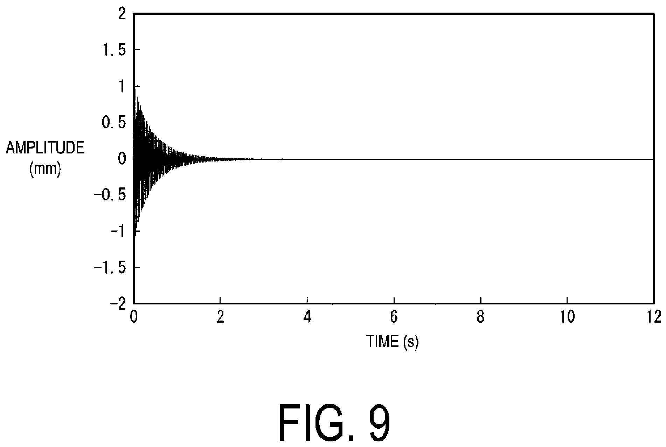

For the obtained laminate, the time (sec) until the vibration damping reached 1/4 was measured, and the loss factor was determined. The results are shown in Table 1. Further, the time waveform of the vibration displacement is illustrated in FIG. 9.

### Comparative Example 1

The pitch-based unidirectional prepreg (A1-1: 0°) was laminated on each of both surfaces of the PAN-based unidirectional prepreg (A1-2: 90°) to obtain a laminate precursor (total thickness: 1.55 mm, thickness of A1-1 (0°): 0.61 mm, thickness of A1-2 (90°): 0.33 mm) having a three-layer structure in which A1-1 (0°)/A1-2 (90°)/A1-1 (0°) were laminated in this order.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 1.55 mm.

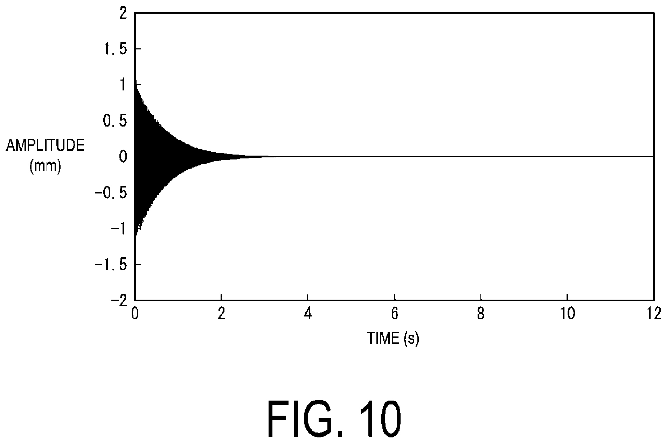

For the obtained laminate, the time (sec) until the vibration damping reached 1/4 was measured, the loss factor was determined, and the deflection amount was further measured. The results are shown in Table 1. Further, the time waveform of the vibration displacement is illustrated in FIG. 10.

### Comparative Example 2

The PAN-based unidirectional prepreg (A1-2: 0°) was laminated on each of both surfaces of the PAN-based unidirectional prepreg (A1-2: 90°) to obtain a laminate precursor (total thickness: 1.51 mm, thickness of A1-2 (0°): 0.59 mm, thickness of A1-2 (90°): 0.33 mm) having a three-layer structure in which A1-2 (0°)/A1-2 (90°)/A1-2 (0°) were laminated in this order.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 1.51 mm.

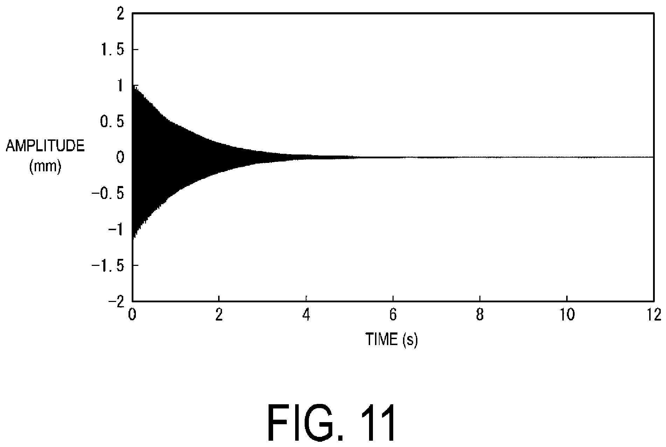

For the obtained laminate, the time (sec) until the vibration damping reached 1/4 was measured, the loss factor was determined, and the deflection amount was further measured. The results are shown in Table 1. Further, the time waveform of the vibration displacement is illustrated in FIG. 11.

### Comparative Example 3

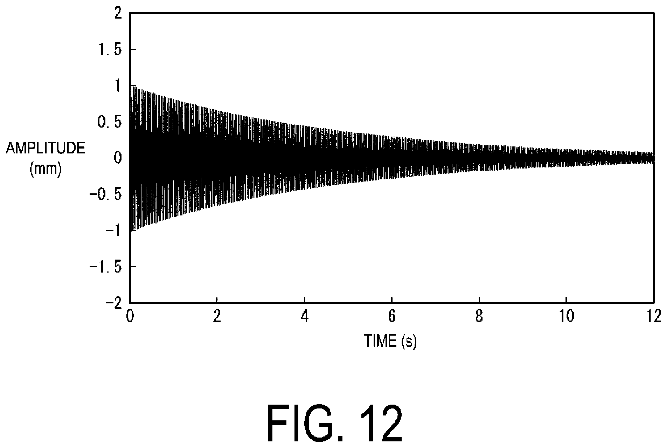

The stainless steel plate (A4-1) was used instead of the laminate, and the time (sec) until the vibration damping reached 1/4 was measured, the loss factor was determined, and the deflection amount was further measured. The results are shown in Table 1. Further, the time waveform of the vibration displacement is illustrated in FIG. 12.

### Comparative Example 4

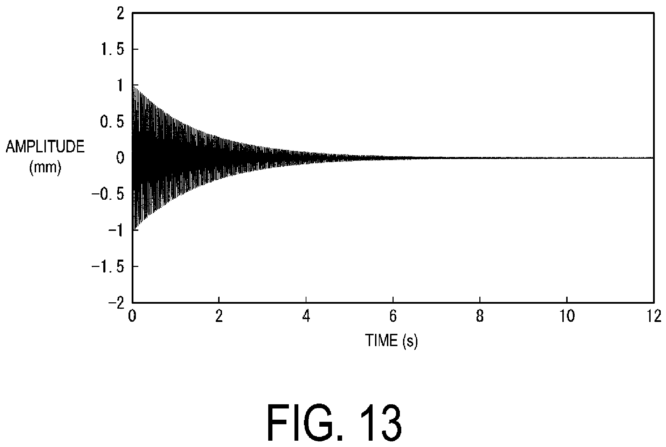

The Al-Mg alloy plate (A3-2) was used in place of the laminate, and the time (sec) until the vibration damping reached 1/4 was measured, and the loss factor was determined. The results are shown in Table 1. Further, the time waveform of the vibration displacement is illustrated in FIG. 13.

### Comparative Example 5

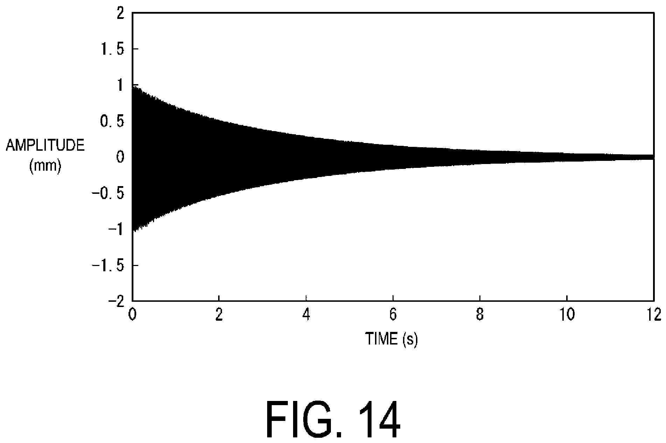

The ceramic plate (A2-3) was used instead of the laminate, and the time (sec) until the vibration damping reached 1/4 was measured, the loss factor was determined, and the deflection amount was further measured. The results are shown in Table 1. Further, the time waveform of the vibration displacement is illustrated in FIG. 14.

### Comparative Example 6

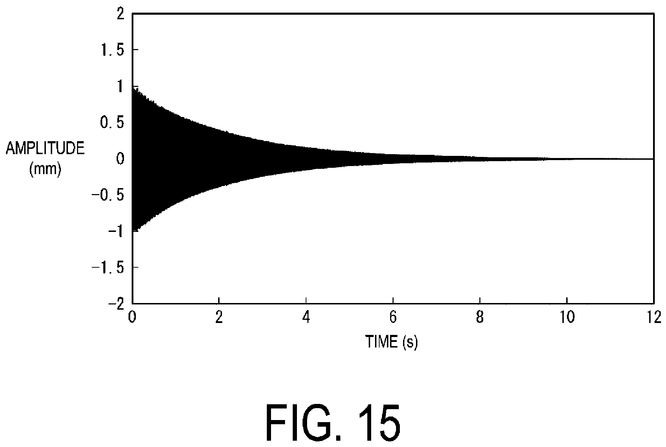

The ceramic plate (A2-4) was used instead of the laminate, and the time (sec) until the vibration damping reached 1/4 was measured, the loss factor was determined, and the deflection amount was further measured. The results are shown in Table 1. Further, the time waveform of the vibration displacement is illustrated in FIG. 15.

### Comparative Example 7

A laminate precursor (total thickness: 2.16 mm) in which the pitch-based unidirectional prepreg (A1-1: 0°) was laminated was obtained.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 2.16 mm.

For the obtained laminate, the loss factor was determined. The results are shown in Table 1.

### Comparative Example 8

Six epoxy resin sheets (B1-1) were stacked with an adhesive to form a second layer. The total thickness of the epoxy resin sheets was 0.60 mm, and the total thickness of the adhesive was 0.10 mm. The PAN-based unidirectional prepreg (A1-2: 0°) was laminated on each of both surfaces of the second layer to obtain a laminate precursor (total thickness: 1.72 mm, thickness of second layer: 0.70 mm) in which A1-2 (0°)/B1-1/A1-2 (0°) were laminated in this order.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 1.52 mm.

The deflection of the obtained laminate, when measured, was as large as 8.75 mm.

### Comparative Example 9

Four epoxy resin sheets (B1-1) were stacked with an adhesive to form a second layer. The total thickness of the epoxy resin sheets was 0.40 mm, and the total thickness of the adhesive was 0.06 mm. The PAN-based unidirectional prepreg (A1-2: 0°) was laminated on each of both surfaces of the second layer to obtain a laminate precursor (total thickness: 1.13 mm, thickness of second layer: 0.46 mm) in which A1-2 (0°)/B1-1/A1-2 (0°) were laminated in this order.

The obtained laminate precursor was temperature-raised to 150°C at 2°C/min under a pressure of 0.7 MPa in an autoclave, and heated and cured at 150°C for 120 minutes to obtain a laminate having a width of 250 mm, a length of 250 mm and a total thickness of 1.52 mm.

In the measurement of the deflection of the obtained laminate, the weight fell since the deflection was large. Therefore, the deflection could not be measured.

**[Table 1]**

| | Laminate | | | | Evaluation | | |
|---|---|---|---|---|---|---|---|
| | Layer configuration of laminate precursor | Proportion (%) of thickness of second layer (b) to total thickness | Total thickness (mm) | Thickness (mm) of second layer (b) | Time (sec) until vibration damping reaches 1/4 | Loss factor | Deflection amount (mm) |
| Example 1 | A1-1 (0°)/A1-2 (90°)/B1-1/A1-2 (90°)/A1-1 (0°) | 6.4 | 1.56 | 0.10 | 0.08 | 0.077 | 2.02 |
| Example 2 | A1-2 (0°)/A1-2 (90°)/B1-1/A1-2 (90°)/A1-2 (0°) | 6.6 | 1.52 | 0.10 | 0.30 | 0.034 | 4.2 |
| Example 3 | A1-1 (0°)/B1-2/A1-1 (0°) | 9.4 | 2.12 | 0.20 | - | 0.075 | - |
| Example 4 | A1-1 (0°)/B2-1/A1-1 (0°) | 9.4 | 2.12 | 0.20 | - | 0.077 | 1.70 |
| Example 5 | A2-1/adhesive/B1-1/adhesive/A2-1 | 6.2 | 1.62 | 0.10 | 0.08 | 0.118 | - |
| Example 6 | A2-2/adhesive/B1-1/adhesive/A2-2 | 6.2 | 1.62 | 0.10 | 0.11 | 0.099 | - |
| Example 7 | A3-1/adhesive/B1-1/adhesive/A3-1 | 6.2 | 1.62 | 0.10 | 0.59 | 0.028 | - |
| Comparative Example 1 | A1-1 (0°)/A1-2 (90°)/A1-1 (0°) | - | 1.55 | - | 0.98 | 0.005 | 1.03 |
| Comparative Example 2 | A1-2 (0°)/A1-2 (90°)/A1-2 (0°) | - | 1.51 | - | 1.76 | 0.005 | 3.24 |
| Comparative Example 3 | A4-1 | - | 1.50 | - | 6.70 | 0.002 | 2.08 |
| Comparative Example 4 | A3-2 | - | 1.50 | - | 2.17 | 0.007 | 5.62 |
| Comparative Example 5 | A2-3 | - | 1.50 | - | 4.52 | 0.002 | 0.45 |
| Comparative Example 6 | A2-4 | - | 1.50 | - | 2.95 | 0.003 | 0.57 |
| Comparative Example 7 | A1-1 (0°) | - | 2.16 | - | - | 0.003 | - |
| Comparative Example 8 | A1-2 (0°)/B1-1/A1-2 (0°) | 40.1 | 1.72 | 0.70 | - | - | 8.75 |
| Comparative Example 9 | A1-2 (0°)/B1-1/A1-2 (0°) | 40.1 | 1.13 | 0.46 | - | - | Deflection amount is large and cannot be measured |

| | | | | | | | |
|---|---|---|---|---|---|---|---|
| The numerical value in parentheses is the orientation angle of the carbon fiber | | | | | | | |

As is clear from the results in Table 1, the laminates obtained in Examples 1 and 2 had a short time until the vibration damping reached 1/4, a large loss factor, and excellent vibration damping properties, as compared with those in Comparative Examples 1 to 6.

The laminates obtained in Examples 3 and 4 also had a large loss factor and excellent vibration damping properties.

### Reference Signs List

10 Laminate precursor
11 First layer (A)
111 First A layer
112 Second A layer
113 Third A layer
114 Fourth A layer
12 Second layer (B)
21 Fixed portion
22 Finger portion
23 Through hole
30 Vibration damping measuring device
31 Test piece
32 Fixing jig
33 Laser displacement meter
200 Laminate
210 First layer (a)
211 First a layer
212 Second a layer
213 Third a layer
214 Fourth a layer
220 Second layer (b)

## Claims

1. A laminate comprising a plurality of first layers (a) and a second layer (b), wherein
each of the plurality of first layers (a) is a layer selected from a carbon fiber-reinforced resin layer (a1), a ceramic layer (a2), and a metallic layer (a3),
the second layer (b) is a layer selected from a layer (b1) mainly containing an epoxy resin (S) (provided that the carbon fiber-reinforced resin layer (a1) is excluded), and a layer (b2) mainly containing a thermoplastic elastomer (T),
the first layers (a) are disposed on both surfaces of the second layer (b), and
a proportion of a thickness of the second layer (b) to a total thickness of the first layers (a) and the second layer (b) is 0.3% or more and less than 30%.

2. The laminate according to claim 1, wherein the laminate has a total thickness of from 1.5 to 20 mm.

3. The laminate according to claim 1, wherein the carbon fiber-reinforced resin layer (a1) includes both a layer containing pitch-based carbon fibers and a layer containing PAN-based carbon fibers.

4. The laminate according to claim 1, wherein the layer (b1) containing the epoxy resin (S) has an elongation at break of 100% or more and 500% or less.

5. The laminate according to claim 1, wherein the layer (b2) containing the thermoplastic elastomer (T) has an elongation at break of 800% or more and 1200% or less.

6. The laminate according to claim 1, wherein the metallic layer (a3) is any one of an aluminum layer, a SUS layer, and a titanium alloy layer.

7. The laminate according to claim 1, wherein the epoxy resin (S) has an aliphatic hydrocarbon skeleton.

8. The laminate according to claim 1, wherein the second layer (b) has a thickness of 0.03 mm or more and 0.5 mm or less.

9. The laminate according to claim 3, wherein the pitch-based carbon fibers have a tensile modulus of 600 GPa or more and 800 GPa or less.

10. The laminate according to claim 3, wherein the PAN-based carbon fibers have a tensile modulus of 200 GPa or more and 400 GPa or less.

11. The laminate according to claim 1, wherein
the carbon fiber-reinforced resin layer (a1) includes a layer (a11₀) containing pitch-based carbon fibers aligned in one direction and a cured product of an epoxy resin (N1), and a layer (β) containing carbon fibers oriented at an orientation angle of 45° or more and 90° or less relative to orientation of the pitch-based carbon fibers contained in the layer (a11₀), and
the layer (β) includes at least one of a layer (a11) containing pitch-based carbon fibers aligned in one direction and a cured product of an epoxy resin (N1) and a layer (a12) containing PAN-based carbon fibers aligned in one direction and a cured product of an epoxy resin (N2).

12. The laminate according to claim 1, wherein the layer (b1) containing the epoxy resin (S) has a tensile modulus of 3 MPa or more and 12 MPa or less and a tensile strength of 10 MPa or more and 50 MPa or less.

13. The laminate according to claim 1, wherein the layer (b2) containing the thermoplastic elastomer (T) has a tensile modulus of 3 MPa or more and 20 MPa or less and a tensile strength of 8 MPa or more and 40 MPa or less.

14. The laminate according to claim 1, wherein the second layer (b) is disposed only in a region including a center of the laminate in a thickness direction.

15. The laminate according to claim 1, wherein the second layer (b) is a layer made of a resin containing no fiber.

16. The laminate according to claim 1 or 2, wherein the second layer (b) has a loss tangent (Tan δ) of 0.2 or more at 20°C in an entire frequency range between 100 Hz and 4000 Hz.

17. The laminate according to claim 1, wherein the laminate has a loss factor of 0.01 or more.

18. The laminate according to claim 1, wherein a time for vibration damping of the laminate to reach 1/4 is 0.7 seconds or less.

19. The laminate according to claim 1, comprising: a fixed portion configured to be fixed to a transfer device; and a finger portion extending from the fixed portion in a substantially U-shape.

20. The laminate according to claim 1, wherein the laminate has a flat plate shape.

21. The laminate according to claim 1, further comprising a layer (c) containing a woven fabric of glass fibers and a matrix resin on at least one of outermost layers of the laminate.

22. A transfer hand comprising the laminate described in any one of claims 1 to 21.

23. A transfer device incorporating the transfer hand described in claim 22.

24. A semiconductor manufacturing device incorporating the transfer hand described in claim 22.

25. A method for manufacturing a laminate, the method comprising pressurizing a laminate precursor in which first layers (A) are disposed on both surfaces of a second layer (B) to obtain a laminate, wherein
each of the first layers (A) is a layer selected from a carbon fiber prepreg layer (A1), a ceramic layer (A2), and a metallic layer (A3),
the second layer (B) is a layer selected from a layer (B1) mainly containing an epoxy resin (S) (provided that a carbon fiber prepreg layer (a1) is excluded), and a layer (B2) mainly containing a thermoplastic elastomer (T), and
a proportion of a thickness of the second layer (B) to a total thickness of the first layers (A) and the second layer (B) is 0.3% or more and less than 30%.
